# EUROPEAN PATENT APPLICATION

(11) **EP 3 296 774 A1**
(43) Date of publication of application: **21.03.2018**
(21) Application number: 16792734.2
(22) Date of filing: 12.05.2016
(51) Int. Cl.: G02B 5/18, G02B 5/32, H01L 31/054

(54) **LIGHT CONDENSING DEVICE, PHOTOVOLTAIC DEVICE, LIGHT CONDENSING SHEET, PHOTOVOLTAIC SHEET, AND METHOD FOR MANUFACTURING LIGHT CONDENSING DEVICE OR PHOTOVOLTAIC DEVICE**

(30) Priority: 12.05.2015 JP 2015097386
(71) Applicant: Egarim Corporation Japan, Shizuoka-shi, Shizuoka 424-0053 (JP); Okamoto Glass Co., Ltd., Kashiwa-shi Chiba 277-0872 (JP); Shimura, Tsutomu, Kamakura-shi, Kanagawa 248-0017 (JP)
(72) Inventor: SHIMURA, Tsutomu, Kamakura-shi, Kanagawa 248-0017 (JP); HORIMAI, Hideyoshi, Numazu-shi, Shizuoka 410-0022 (JP); KASEZAWA, Toshihiro, Shizuoka-shi, Shizuoka 424-0053 (JP); TABUCHI, Hiroshi, Kashiwa-shi, Chiba 277-0872 (JP)
(74) Representative: Grünecker Patent- und Rechtsanwälte PartG mbB
(86) International application number: PCT/JP2016/064088
(87) International publication number: WO 2016/182009

(57) **Abstract**

To provide a photovoltaic device and a light condensing device having a high condensing rate which can be manufactured easily and at low cost. [Solution] This light condensing device is provided with: a light-guiding substrate for causing light to propagate between a rear-side surface and a front-side surface for receiving light from a light source; a reflective layer for light guiding, in which a reflection-type hologram is formed for reflecting light incident at a first incidence angle less than the critical angle of the light-guiding substrate at a reflection angle greater than the critical angle, the reflective layer being provided to the rear-side surface; and an emission window for causing light incident at a second incidence angle equal to or greater than the critical angle to be emitted from the light-guiding substrate, the emission window being provided to the front-side surface and/or the rear-side surface.

## Description

### Technical Field

The present invention relates to a technique of condensing light from a light source to generate electric power by the condensed light, and in particular to a light condensing device, a photovoltaic device, a light condensing sheet, a photovoltaic sheet, and a method for manufacturing a light condensing device or a photovoltaic device.

### Background Art

Recently, from a viewpoint of effectively utilizing natural energy, installation of a solar power generation device in a building, various facilities, a house, and the like has been advanced, and a solar power generation device using a window glass of a house or the like has been also proposed (see, e.g., Patent Literature 1). A power generating window glass described in Patent Literature 1 comprises a transparent substrate, a light controlling film provided on a light incident surface side of the transparent substrate, and a solar battery disposed on an end of the transparent substrate. In the light controlling film, scattering occurs only when light is incident at a predetermined angle, and some of the scattered light is propagated inside the transparent substrate by total reflection to be received by the solar battery disposed at the end of the transparent substrate.

Furthermore, a sunlight condensing apparatus to be installed on a roof of a house or the like has also been proposed (see, e.g., Patent Literature 2). The sunlight condensing apparatus described in Patent Literature 2 comprises a light-guiding layer, an angle turning layer disposed on a front surface on a light source side of the light-guiding layer, and a plurality of surface features formed on a rear surface of the light-guiding layer. Light from the light source is incident on the angle turning layer at a first angle and turned toward the light-guiding layer at a second angle, and subsequently redirected to a third angle by the surface features of the light guide, and introduced via the light-guiding layer by a plurality of total reflections.

### Citation List

### Patent Literature

PTL1: JP-A-2012-23089
PTL2: JP-A- 2012-503221

### Summary of Invention

### Technical Problem

The power generating window glass described in Patent Literature 1 (see Fig. 19A) is provided with a light controlling film 12 on a light incident surface S1 of a transparent substrate (window glass) 10, and capable of condensing light irradiated from a light source to some extent by using total reflection inside the transparent substrate 10 and the like.

However, among scattering light based on incident light L1 generated at the light controlling film 12, scattering light L1a incident on the transparent substrate 10 at an angle not less than a critical angle is propagated toward an end D inside the transparent substrate 10, but scattering light L1b incident on the window glass 10 at an angle less than the critical angle is transmitted through the window glass 10 to be emitted from a light emission surface S2. Consequently, the power generating window glass described in Patent Literature 1 uses only some of the light scattered by the light controlling film 12 in guiding light to the solar battery 11, resulting in low light condensing efficiency.

Furthermore, in the power generating window glass, a solar battery 11 is disposed to be in contact with the end D (cross section defining the thickness) of the window glass, so that it is very difficult to install a solar battery to an existing window glass or window structure afterward. In addition, in the power generating window glass described in Patent Literature 1, the light controlling film 12 is provided on the outdoor side, so that a surface of the light controlling film 12 on the outdoor side is readily tainted and deteriorated, resulting in decreased light usage efficiency and lifetime as well as a risk of damage in a case where a physical force is applied from the outdoor side. Furthermore, providing the light controlling film on the outdoor side of an existing window glass provided in a building, a house, or the like generally involves high-place work, resulting in danger and requiring a cost.

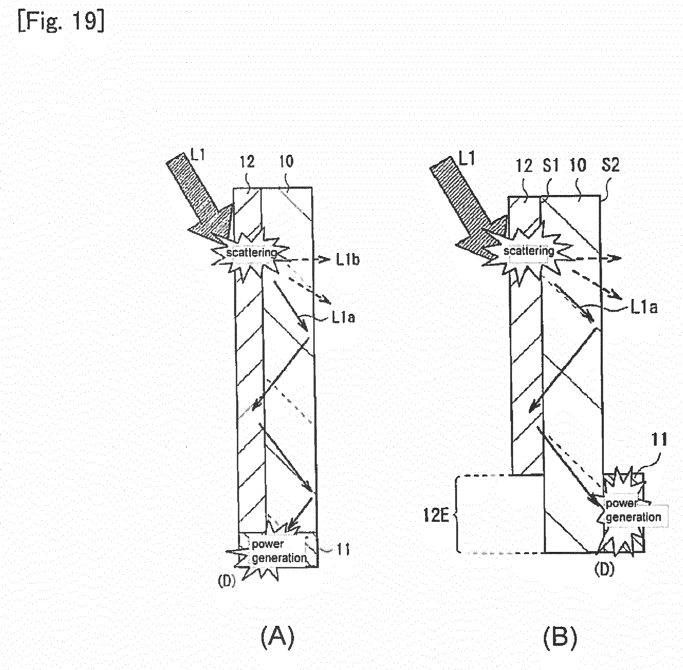

Furthermore, Patent Literature 1 also describes an aspect in which the solar battery 11 is provided on a lower surface on the interior side of the window glass (see Fig. 19B). In this case, the solar battery 11 can be provided easily as compared with the case where the solar battery 11 is disposed to be in contact with the end D (cross section defining the thickness) of the window glass (see Fig. 19A). However, such a solar battery receives light propagated inside the window glass by total reflection and incident at not less than the critical angle, so that usage efficiency of light and thus power generation efficiency are lowered as compared with the case of receiving light at right angle with respect to a light receiving surface of the solar battery. Furthermore, in the power generating window glass described in Patent Literature 1, the solar battery needs to be attached firmly to the window glass, limiting arrangement of the solar battery.

In contrast, according to an aspect of the sunlight condensing apparatus described in Patent Literature 2 (see Fig. 20), prismatic features 102 composed of V-grooves are formed on the rear surface of the light guide 101, and it is considered that this makes it possible to introduce the light incident within an angle range close to right angle (a cone 106) into the light guide.

However, in such a sunlight condensing apparatus, light incident from the range outside the cone 106 is transmitted through the light guide, so that only some of incident light is used, resulting in low light condensing efficiency similar to the device described in Patent Literature 1. Furthermore, when the sun is used as a light source, although the incident angle with respect to the light guide is varied depending on the time zone or season, Patent Literature 2 does not examine a method of efficiently condensing light depending on variation of the incident angle of light from a light source.

Furthermore, in the sunlight condensing apparatus described in Patent Literature 2, a fine structure (prism) needs to be formed on the rear surface of the light guide (glass, acrylic, etc.), so that it is difficult and requires a cost to apply the sunlight condensing apparatus to an existing window glass or window structure. More importantly, applying a fine structure (prism) to a window glass distorts landscape to seriously diminishes visibility, so that the application is not preferable in a case of seeking scenery. In addition, the sunlight condensing apparatus described in Patent Literature 2 provides a photocell at an end of the light guide similar to the device described in Patent Literature 1, limiting arrangement of the photocell.

The present invention has been conceived in light of the above problems, and an object thereof is to provide a light condensing device, a photovoltaic device, a light condensing sheet, a photovoltaic sheet, and a method for manufacturing a light condensing device or a photovoltaic device capable of solving at least a part of the above-mentioned problems.

### Solution to Problem

To solve the above problems, a light condensing device according to the invention comprises: a light-guiding substrate configured to propagate light between a front surface that receives light from a light source and a rear surface; a reflection layer for guiding light provided on the rear surface, in which a reflection-type hologram is formed, the reflection-type hologram being configured to reflect light, incident at a first incident angle less than a critical angle of the light-guiding substrate, at a reflection angle greater than the critical angle; and an emission window provided on at least one of the front surface and the rear surface, the emission window being configured to emit light, incident at a second incident angle of not less than the critical angle, from the light-guiding substrate.

In the above light condensing device, the emission window may include a transmission layer for emission in which a transmission-type hologram is formed, the transmission-type hologram being configured to refract the light, incident at the second incident angle not less than the critical angle, at a refraction angle less than the critical angle. Also, the emission window may include a reflection layer for emission in which a reflection-type hologram is formed, the reflection-type hologram being configured to reflect the light, incident at the second incident angle not less than the critical angle, at a reflection angle less than the critical angle. In addition, the emission window may include a diffusion plate. The emission window includes an emission optical system having an inclination with respect to the rear surface or the front surface of the light-guiding substrate in the light condensing device.

In the light condensing device, the reflection-type hologram in the reflection layer for guiding light is preferably configured to reflect light incident at the first incident angle within a predetermined angle range for an elevation angle direction or an azimuth angle direction. Preferably, a plurality of types of reflection-type holograms having different reflection angles are formed in the reflection layer for guiding light.

Preferably, the transmission-type hologram of the transmission layer for emission is configured to emit the light, incident at the second angle different in an elevation angle direction or an azimuth angle direction, in one direction at a predetermined refraction angle. Furthermore, the transmission-type hologram of the transmission layer for emission may be configured to emit light incident at the first incident angle in one direction at a predetermined refraction angle.

In the reflection layer for guiding light, a plurality of the reflection-type holograms having a circular shape may be formed to partially overlap with each other. Also, a plurality of the reflection-type holograms having a crescent shape may be formed.

A photovoltaic device according to the invention is a device in which a photocell configured to receive the light emitted from the emission window to generate electric power is disposed in the light condensing device.

A light condensing sheet according to the invention is a light condensing sheet to be stuck to a light-guiding substrate configured to propagate light between a front surface that receives light from a light source and a rear surface. The light condensing sheet includes: a reflection layer for guiding light in which a reflection-type hologram configured to reflect light, incident at a first incident angle less than a critical angle of the light-guiding substrate, at a reflection angle greater than the critical angle; and an emission window formed by a transmission-type hologram, a reflection-type hologram, or a diffusion plate, the emission window being configured to emit light incident at a second incident angle not less than the critical angle.

A photovoltaic sheet according to the invention is a photovoltaic sheet to be stuck to a light-guiding substrate configured to propagate light between a front surface that receives light from a light source and a rear surface. The photovoltaic sheet includes: a reflection layer for guiding light in which a reflection-type hologram configured to reflect light, incident at a first incident angle less than a critical angle of the light-guiding substrate, at a reflection angle greater than the critical angle; an emission window formed by a transmission-type hologram, a reflection-type hologram, or a diffusion plate, the emission window being configured to emit light incident at a second incident angle of not less than the critical angle,; and a photocell configured to receive the light emitted from the emission window to generate electric power.

A method for manufacturing a light condensing device according to the invention is a method for manufacturing a light condensing device configured to condense light from a light source. In the method: a reflection sheet for guiding light in which a reflection-type hologram is formed is stuck to a rear surface of a light-guiding substrate configured to propagate light between a front surface that receives light from a light source and the rear surface, the reflection-type hologram being configured to reflect light, incident at a first incident angle less than a critical angle of the light-guiding substrate, at a reflection angle greater than the critical angle; and a sheet for an emission window formed by a transmission-type hologram, a reflection-type hologram, or a diffusion plate is stuck to at least one of the front surface and the rear surface of the light-guiding substrate, the sheet for the emission window being configured to emit light incident at a second incident angle of not less than the critical angle.

A method for manufacturing a photovoltaic device according to the invention is a method for manufacturing a photovoltaic device configured to condense light from a light source to generate electric power. In the method: a reflection sheet for guiding light in which a reflection-type hologram is formed is stuck to a rear surface of a light-guiding substrate configured to propagate light between a front surface that receives light from a light source and the rear surface, the reflection-type hologram being configured to reflect light, incident at a first incident angle less than a critical angle of the light-guiding substrate, at a reflection angle greater than the critical angle; a sheet for an emission window formed by a transmission-type hologram, a reflection-type hologram, or a diffusion plate is stuck to at least one of the front surface and the rear surface of the light-guiding substrate, the sheet for the emission window being configured to emit light incident at a second incident angle of not less than the critical angle; and a photocell is provided at a position to receive the light emitted from the sheet for emission window.

A method for manufacturing a light condensing device according to the invention is a method for manufacturing a light condensing device configured to condense light from a light source. The method includes a step of sticking a light condensing sheet to a surface of a light-guiding substrate, the light condensing sheet being configured to include: a reflection layer for guiding light in which a reflection-type hologram is formed, the reflection-type hologram being configured to reflect light, incident at a first incident angle less than a critical angle of the light-guiding substrate, at a reflection angle greater than the critical angle; and an emission window configured to emit light incident at a second angle of not less than the critical angle. The method for manufacturing a light condensing device may include, before the step of sticking a light condensing sheet to a surface of a light-guiding substrate, one or more steps among: a step of peeling off a light condensing sheet stuck to the light-guiding substrate; a step of washing the surface of the light-guiding substrate; and a step of shaping the light condensing sheet to match a size or a shape of the light-guiding substrate.

A method for manufacturing a photovoltaic device according to the invention is a method for manufacturing a photovoltaic device configured to condense light from a light source to generate electric power. The method includes a step of sticking a photovoltaic sheet to a surface of a light-guiding substrate, the photovoltaic sheet being configured to include: a reflection layer for guiding light in which a reflection-type hologram is formed, the reflection-type hologram being configured to reflect light, incident at a first incident angle less than a critical angle of the light-guiding substrate, at a reflection angle greater than the critical angle; and an emission window configured to emit light incident at a second angle not less than the critical angle. The method for manufacturing a photovoltaic device may include, before the step of sticking a photovoltaic sheet to a surface of a light-guiding substrate, one or more steps among: a step of peeling off a photovoltaic sheet stuck to the light-guiding substrate; a step of washing the surface of the light-guiding substrate; and a step of shaping the photovoltaic sheet to match a size or a shape of the light-guiding substrate.

### Advantageous Effects of Invention

The light condensing device according to the invention makes it possible to efficiently collecting light while ensuring lighting properties and visibility. It also allows collected light to reach in a desired direction. In the light photovoltaic device according to the invention, the emission window allows condensed light to reach in a desired direction, so that the photocell can be disposed at any place without restriction by surrounding environment. Also, the angle between the light emitted from the emission window and the light receiving surface of the photocell can be set appropriately so that power generation efficiency can improved. The light condensing device or the photovoltaic device of the invention can be configured easily by using an existing window glass. Other effects of the invention will be described in the description of embodiments.

### Brief Description of Drawings

Fig. 1 is a schematic configuration diagram of a light condensing device and a photovoltaic device according to the invention.
Fig. 2 shows another example of the light condensing device and the photovoltaic device according to the invention.
Fig. 3 shows another example the light condensing device and the photovoltaic device according to the invention.
Fig. 4 shows a first configuration example of an emission window.
Fig. 5 shows a second configuration example of the emission window.
Fig. 6 shows a third configuration example of the emission window.
Fig. 7 shows a fourth configuration example of the emission window.
Fig. 8 shows a first configuration example of a light condensing sheet.
Fig. 9 shows a second configuration example of the light condensing sheet.
Fig. 10 shows a third configuration example of the light condensing sheet.
Fig. 11 shows a configuration example of a photovoltaic sheet.
Fig. 12 is an illustrative diagram illustrating a diurnal motion of the sun for each season.
Fig. 13 is an illustrative diagram illustrating a device and a method for manufacturing a reflection-type hologram.
Fig. 14 is an illustrative diagram illustrating an example of a light shielding mask.
Fig. 15 is an illustrative diagram illustrating another example of the light shielding mask.
Fig. 16 is an example in which circular reflection-type holograms are formed.
Fig. 17 is an illustrative diagram illustrating a light flux of object light in the case where a light shielding mask is used.
Fig. 18 is an example in which reflection-type holograms having a crescent shape are formed.
Fig. 19 is an illustrative diagram illustrating a first conventional example. Figs. 19A and 19B are respectively cited from Fig. 5A and Fig. 12 of Patent Literature 1.
Fig. 20 is an illustrative diagram illustrating a second conventional example.

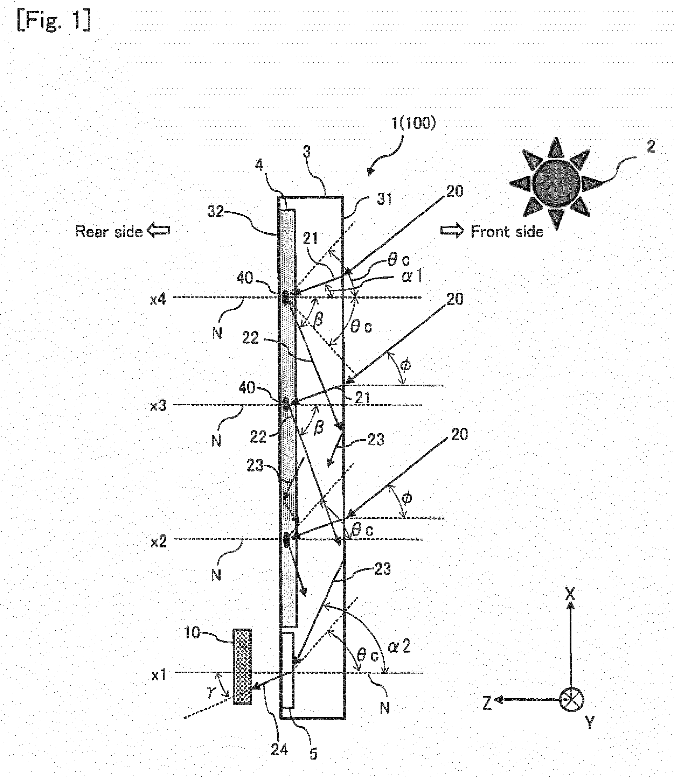

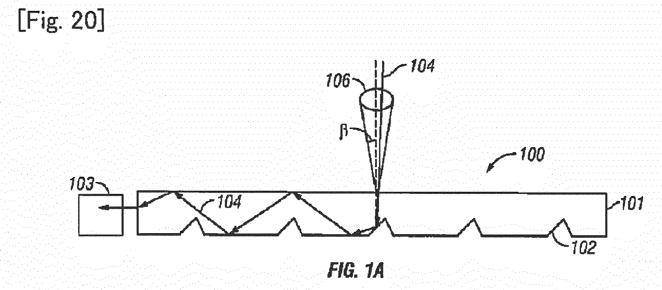

Fig. 20 is cited from Fig. 1A of Patent Literature 2.

### Description of Embodiments

Hereinafter, an embodiment of the invention will be described with reference to the drawings. However, the invention is not limited to the following examples.

### [Configuration of Light Condensing Device and Photovoltaic Device]

Fig. 1 is a schematic configuration diagram of a light condensing device 1 and a photovoltaic device 100 of the invention.

The light condensing device 1 of the invention is a device for condensing light 20 irradiated from a light source 2, and comprises a light-guiding substrate 3, a reflection layer 4 for guiding light, and an emission window 5. Then, the photovoltaic device 100 of the invention is a combination of the light condensing device 1 and a photocell 10 for receiving light condensed by and emitted from the light condensing device 1 to generate electric power.

The light condensing device 1 or the photovoltaic device 100 according to the invention is applicable to a window of, for example, a house, a building, various facilities, and a vehicle. Furthermore, the light condensing device 1 or the photovoltaic device 100 is also applicable to a construction for daylighting or ventilation other than a window, for example, a wall surface or a roof of an architectural structure, a sound insulating wall of a carport, an arcade, a greenhouse, an express way, a railroad, etc., a wall surface of a tunnel, and the like. In Fig. 1, the sun is exemplified as the light source 2, but the invention is not limited thereto. The light condensing device 1 or the photovoltaic device 100 of the invention is also capable of using light such as moonlight, another illumination (room illumination, street lamp, tunnel illumination), and a headlight of a car as the light source 2.

Hereinafter, in the present specification, the side of the light source 2 of the light condensing device 1 (or the photovoltaic device 100) is referred to a front side, and the direction opposite to the light source 2 thereof is referred to as a rear side. Furthermore, in the present specification, when the size of the light condensing device 1 is described by a length (X axis direction), a side (Y axis direction), and a thickness (Z axis direction), angles such as an incident angle α, a reflection angle β, a refraction angle γ, and a critical angle θc of light described below are defined with respect to normal line N of a plane defined as a standard by the length (X axis direction) × the side (Y axis direction).

The light-guiding substrate 3 is a substrate for propagating light between a front surface 31 that receives the light 20 from the light source 2 and a rear surface 32, and is composed of a transparent material having a refractive index higher than that of air. Preferably, the light-guiding substrate 3 has a flat plate shape, but may include a curved surface. It is sufficient that the transparent material is a material having transmittivity with respect to incident light, and for example, a glass, a plastic, or the like may be employed. Furthermore, the light-guiding substrate 3 may be composed of a photosensitive material allowing a hologram to be recorded therein.

Generally, a hologram is recorded in a hologram photosensitive material. The hologram sensitive material typically includes at least a hologram recording layer including a photosensitive material, and a base material supporting the hologram recording layer. Silver salt, dichromated gelatin, photopolymer, photoresistor, or the like is used as the hologram recording layer, and a resin such as polyethylene film, polypropylene film, and polyfluoroethylene based film is used as the base material. For example, when a photopolymer is used as a hologram recording material, the hologram recording material is formed by a monomer for recording a fringe pattern, a matrix for keeping the shape of the recording material, and a non- reactive component or various additive agents to be added as needed. Among them, the matrix is a component to keep the shape of the recording material, is required to have a high light transmittance and transparency, and preferably has a refractive index slightly lower than that of the monomer to facilitate refractive index modulation, and a urethane resin or an epoxy resin is typically used. In contrast, the monomer is a component for recording a fringe pattern and is required to have a high light transmittance and transparency, and the monomer preferably has a refractive index slightly higher than that of the matrix, and records a fringe pattern by photocuring. The monomer mainly includes a photo-cationic polymerization system and a photo-radical polymerization system, and an alicyclic epoxy compound such as a silicon based epoxide is used for the photo-cationic polymerization system, and a vinyl compound such as vinylcarbazole, styrene derivative, acrylate, and prepolymer thereof is used for the photo-radical polymerization system. When the hologram photosensitive material is used for the light-guiding substrate 3 itself, for example, a large portion of the light-guiding substrate may be composed of the matrix, and the monomer, the non- reactive component, various additive agents, and the like may be dispersed near its surface.

The critical angle θc at which total reflection occurs inside the light-guiding substrate 3 is defined by the ratio between the refractive index of air and the refractive index of the material constituting the light-guiding substrate 3. For example, when the light-guiding substrate 3 is formed of a float glass (refractive index 1.51) generally used for a window glass, supposing that the refractive index of air is 1.0, the critical angle θc becomes about 42°.

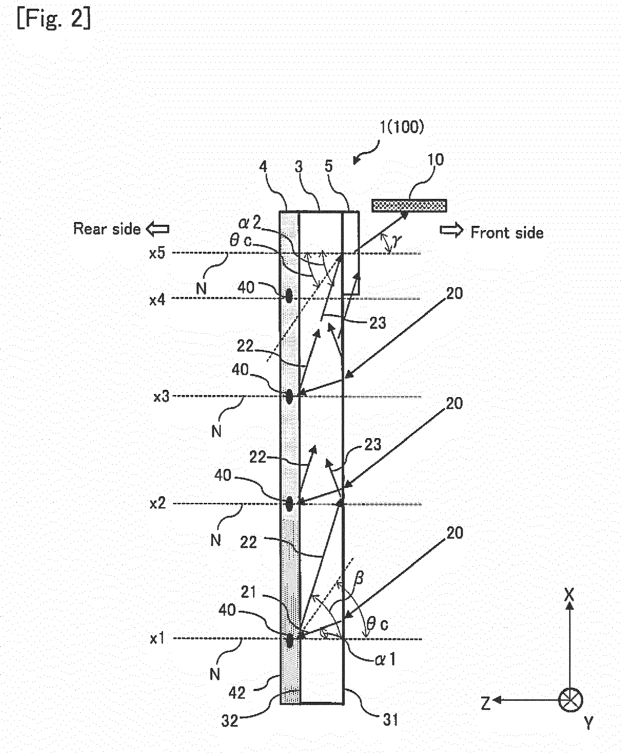

The reflection layer 4 for guiding light is provided on at least a part of the rear surface 32 of the light-guiding substrate 3, and includes a plurality of reflection-type holograms 40. The reflection layer 4 for guiding light may be composed on a part of the material itself (hologram photosensitive material) composing the light-guiding substrate 3 as illustrated in Fig. 1. In this case, the refractive index of the reflection layer 4 for guiding light has a value substantially equal to that of the material of light-guiding substrate 3, so that no light refraction occurs at the boundary between the area in which the reflection layer 4 for guiding light is composed and the area in which no reflection layer 4 for guiding light is composed, making it easy to design diffraction by the hologram. Furthermore, the reflection layer 4 for guiding light may be formed by another material (hologram photosensitive material) different from that of the light-guiding substrate 3 and jointed with the light-guiding substrate 3 as illustrated in Fig. 2, etc. described below.

The reflection-type hologram 40 of the reflection layer 4 for guiding light is configured to reflect at least a part of light 21 incident at a first incident angle α1 less than a critical angle θc of the light-guiding substrate 3 (that is, in the range of 0° ≤ α1 < θc) at a reflection angle β greater than critical angle θc as light 22. The light 21 incident at the first incident angle α1 may denote light of one direction incident at a certain angle within the angle range, a light flux integrating a plurality of light beams incident within an angle range among the angle range, or a part of the light flux integrating a plurality of light beams incident within a wide-angle range including the angle range. The reflection angle β at the reflection-type hologram 40 may be set to one value, or may be set to different values depending on a position at which the reflection-type hologram 40 is formed on the reflection layer 4 for guiding light.

For example, as illustrated in Fig. 1, in the reflection layer 4 for guiding light, when reflection-type holograms 40 are formed at each of positions x2, x3, x4 ··· on the X axis, the reflection angle β (x) at the reflection-type hologram 40 at position x can be made to be β(x2) ≠ β(x3) ≠ β(x4). Since the reflection angle can be set freely depending on the position, it can be designed to reduce a loss due to redundant diffraction and absorption depending on arrangement of the emission window 5, positional relation between the light condensing device 1 and the light source 2, intended use of the light condensing device 1, or the like. For example, when all reflection angles β are the same, the holograms 40 in the reflection layer 4 for guiding light interfere with light of angle α1 less than a critical angle θc from the light source to reproduce light of angle β not less than the critical angle θc, but it may interfere with the light of angle β to cause the loss. Consequently, only by setting a plurality of reflection angles β, interference generated when the light of angle β not less than the critical angle θc reflected at one of the holograms 40 passes through another hologram 40 again can be reduced so as to reduce the loss. Furthermore, in order to reduce absorption (attenuation) of light passing inside the light-guiding substrate, the reflection angle is preferably set large as far as possible to make optical path short as for the hologram 40 at a position away from the emission window 5. For example, in the case of the light condensing device illustrated in Fig. 1, the reflection angle β(x) is preferably designed to satisfy β(x2) < β(x3) < β(x4).

The emission window 5 is provided on at least one of the front surface and the rear surface of the light-guiding substrate 3, and refracts, diffracts or reflects light 23 incident at a second incident angle α2 not less than the critical angle θc of the light-guiding substrate 3 to be a predetermined angle γ and emits it from the light-guiding substrate 3. The angle γ of emission light 24 can be appropriately set depending on the number and arrangement of photocells 10, and the emission light 24 may be aligned in one direction, or may have a plurality of angles, or may have a constant angle range.

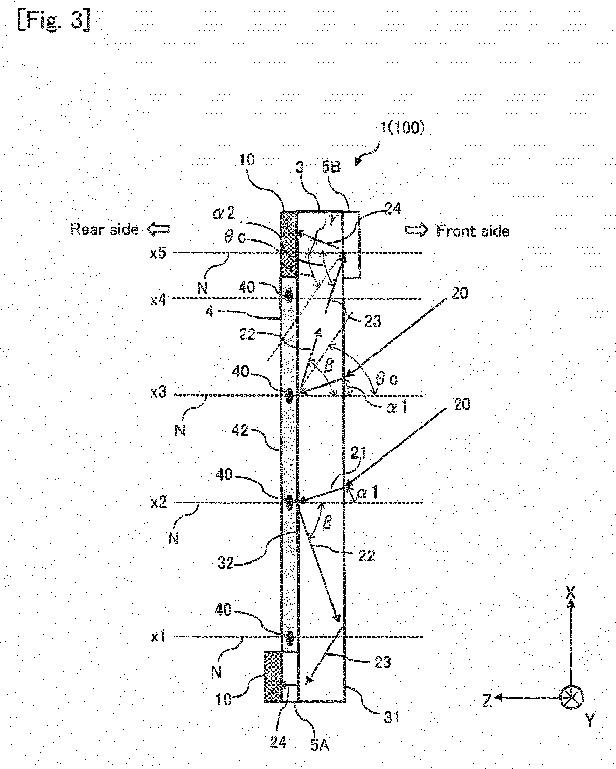

As illustrated in Fig. 1, although the emission window 5 is preferably provided on the rear surface 32 of the light-guiding substrate 3 (the same side as the reflection layer 4 for guiding light), the emission window 5 may be provided on the front surface 31 of the light-guiding substrate 3 as illustrated in Fig. 2 described below below. Furthermore, the emission window 5 may be provided on both the front surface and the rear surface of the light-guiding substrate 3 as illustrated in Fig. 3 described below.

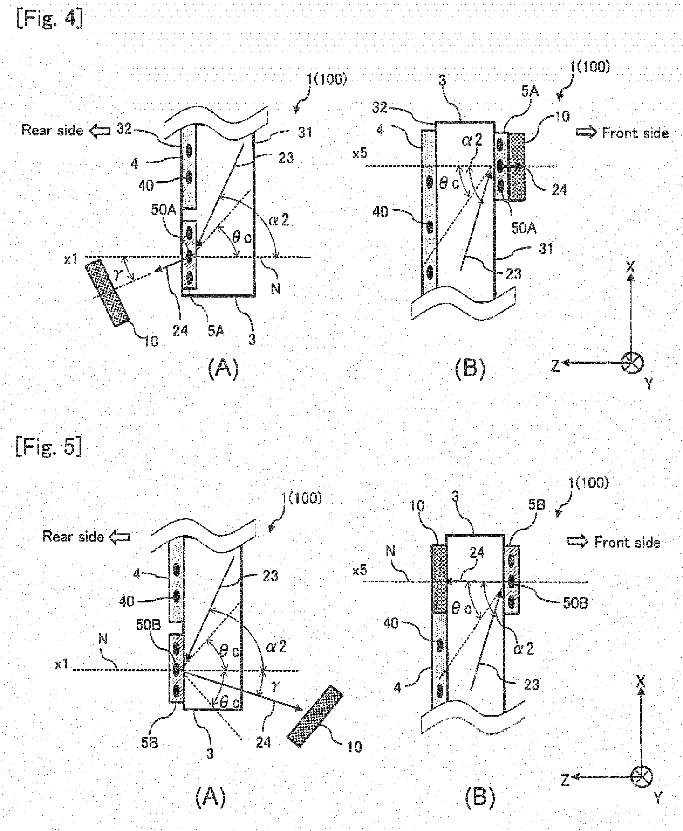

Furthermore, as illustrated in Fig. 1, the emission window 5 may be composed on a part of the material itself (hologram photosensitive material) structuring the light-guiding substrate 3. In this case, a value of the refractive index of the emission window 5 becomes substantially equal to that of the material of the light-guiding substrate 3, making it easy to design diffraction by the hologram. Also, the emission window 5 may be formed on a member different form the light-guiding substrate 3, and may be jointed with a part of the front surface 31 or the rear surface 32 of the light-guiding substrate 3 as illustrated in Fig. 2 and Fig. 3 described below. Specific configuration examples of the emission window 5 will be described below by using Fig. 4 to Fig. 7.

The photocell 10 is a device disposed at a position for receiving the light 24 emitted from the emission window 5 and photoelectrically converting the emitted light 24 to generate electric power. The photocell 10 is preferably thin, and more preferably, the photocell 10 is composed by a light-transmission-type module that does not spoil scenery. In the light condensing device 1 according to the invention, by appropriately designing the emission window 5, condensed light can be emitted in an appropriate direction so that the photocell 10 can be disposed at an appropriate position depending on an emission direction of the light from the light condensing device 1. In Fig. 1, an example is illustrated in which the photocell 10 is disposed at a position in parallel with the emission window 5 with a gap, but the invention is not limited thereto. For example, the photocell 10 may be disposed at right angle with respect to the emission window 5 as illustrated in Fig. 2 described below, or may be provided to be adjacent to a surface of the emission window 5 or the light condensing substrate 3 as illustrated in Fig. 3 described below. Furthermore, the photocell 10 may be obliquely disposed with respect to the emission window 5 as illustrated in Fig. 4A described below.

Fig. 2 and Fig. 3 illustrate another example of the light condensing device 1 and the photovoltaic device 100 according to the invention. The light condensing devices 1 or the photovoltaic devices 100 illustrated in of Fig. 2 and Fig. 3 are different from the example illustrated in Fig. 1 in that the reflection layer 4 for guiding light and the emission window 5 are composed separately from the light-guiding substrate 3, and a members provided with the reflection layer 4 for guiding light and the emission window 5 are jointed with the light-guiding substrate 3. In this case, selecting a material having the substantially same refractive index as that of the light-guiding substrate 3 as a hologram photosensitive material composing the reflection layer 4 for guiding light prevents light form being refracted at the boundary surface between the light-guiding substrate 3 and the reflection layer 4 for guiding light, making it easy to design diffraction by the reflection-type hologram 40 of the reflection layer 4 for guiding light.

Furthermore, Fig. 2 is different from the example illustrated in Fig. 1 also in that emission window 5 is disposed on the front surface 31 of the light-guiding substrate 3 and the photocell 10 is disposed at right angle with respect to the emission window 5. Fig. 3 is different from the example illustrated in Fig. 1 in that the transmission-type emission window 5 is provided on the rear surface 32 of the light-guiding substrate 3 and the photocell 10 is disposed to be adjacent to a surface of the transmission-type emission window 5, and the reflection-type emission window 5 is provided on the front side surface 31 of the light-guiding substrate 3 and the photocell 10 is disposed at the position where the emission light 24 reflected at the reflection-type emission window 5 is irradiated by joining therewith the rear surface 32 of the light-guiding substrate 3. In Fig. 2 and Fig. 3, the components to which the reference numerals identical to those in Fig. 1 have the same functions as those of the corresponding components in Fig. 1, so that their detailed description will be omitted.

Fig. 4 to Fig. 7 respectively are first to fourth configuration examples of the emission window 5 in the light condensing device 1 or the photovoltaic device 100 according to the invention.

First, in the first configuration example illustrated in Fig. 4, the output window 5 is composed as a transmission layer 5A for emission in which a plurality of transmission-type holograms 50A are formed in a hologram photosensitive material. The transmission-type hologram 50A of the transmission layer 5A for emission is configured to, upon receiving the light 23 incident at the second incident angle α2 not less than the critical angle θc of the light-guiding substrate 3, refracts the light 23 to be a predetermined angle γ and emits it the refracted light in one direction from the light-guiding substrate 3 as the emission light 24. In the case of the transmission-type emission window 5, the angle γ becomes a refraction angle. In Fig. 4A, the transmission layer 5A for emission is provided in a part of the rear surface 32 of the light-guiding substrate 3, and in Fig. 4B, the transmission layer 5A for emission is provided on a part of the front surface 31 of the light-guiding substrate 3.

The refraction angle γ by the transmission-type hologram 50A can be appropriately set on the basis of the position at which the photocell 10 is disposed. In order to increase power generation efficiency of the photocell 10, the refraction angle γ is preferably set such that the light 24 is incident on a light receiving surface of the photocell 10 at substantially right angle. In Fig. 4A, the photocell 10 is obliquely provided with respect to the transmission layer 5A for emission, and the refraction angle γ is set such that the light 24 is made incident on the light receiving surface of the photocell 10 at right angle. In Fig. 4B, the photocell 10 is provided to be adjacent to the transmission layer 5A for emission, and refraction angle γ is set at substantially 0° so that the light 24 is made incident on the light receiving surface of the photocell 10 at right angle. As illustrated in Fig. 1, even when the photocell 10 is provided in parallel with the transmission layer 5A for emission with a constant gap, the refraction angle γ by the transmission-type holograms 50A is preferably set at substantially 0°. However, as illustrated in Fig. 2, it may be designed so that the light 24 is obliquely incident with respect to the photocell 10. In this manner, in the transmission-type hologram 50A, the angle γ by diffraction can be appropriately set so as to orient the condensed light in the direction in which the photocell 10 is disposed.

Furthermore, the transmission-type hologram 50A of the transmission layer 5A for emission may be configured to emit the light 21 incident at the first incident angle α1 less than the critical angle θc of the light-guiding substrate 3 in one direction from the light-guiding substrate 3 as the emission light 24 of the predetermined angle γ. Although the light 21 incident on the transmission layer 5A for emission at the first incident angle α1 less than the critical angle θc of the light-guiding substrate 3 is emitted in air from the transmission layer 5A for emission at the angle at which the light 21 is incident on the light-guiding substrate 3 in normal cases, this configuration makes it possible to orient even the light 21, incident at the first incident angle α1 less than the critical angle θc, in one direction as the emission light 24 of a predetermined angle γ by the diffraction of the transmission-type holograms 50A, so that the light that reaches the light receiving surface of the photocell 10 can be increased.

Next, in the second configuration example illustrated in Fig. 5, the emission window 5 is composed as a reflection layer 5B for emission in which a plurality of reflection-type holograms 50B are formed in a hologram photosensitive material. The reflection-type hologram 50B of the reflection layer 5B for emission is configured to, upon receiving the light 23 incident at the second incident angle α2 not less than the critical angle θc of the light-guiding substrate 3, reflects the light 23 at a predetermined angle γ and emits it the reflected light in one direction from the light-guiding substrate 3 as the emission light 24. In the case of the reflection-type emission window 5 , the angle γ becomes a reflection angle. The reflection angle γ by the reflection-type hologram 50B can be appropriately set on the basis of the position at which the photocell 10 is disposed.

In Fig. 5A, the reflection layer 5B for emission is provided on a part of the rear surface 32 of the light-guiding substrate 3, and reflects the light 24 toward the photocell 10 disposed on the front of the light-guiding substrate 3. In Fig. 5B, like Fig. 3, the reflection layer 5B for emission is provided on a part of the front surface 31 of the light-guiding substrate 3, and reflects the light 24 toward the photocell 10 provided on a part of the rear surface 32 of the light-guiding substrate 3.

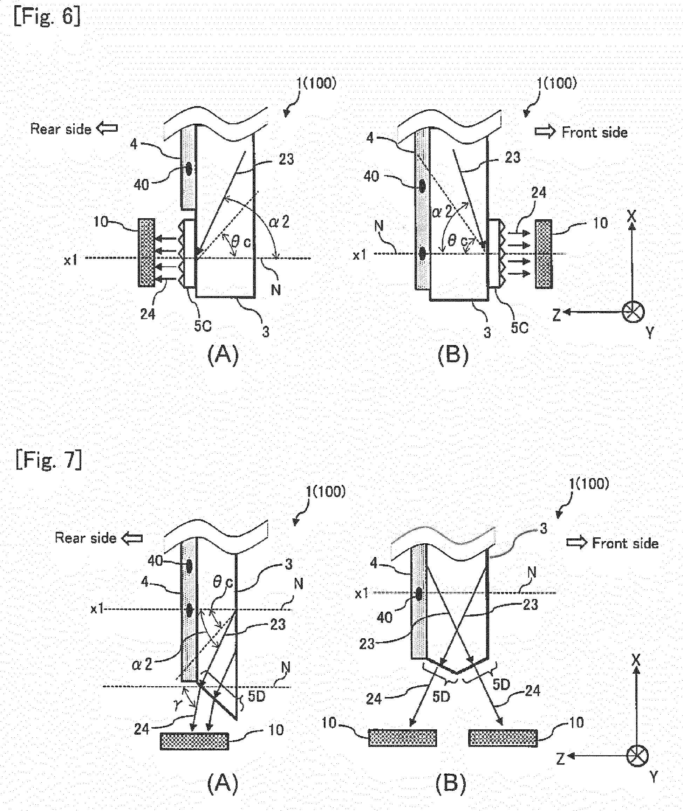

In the third configuration example illustrated in Fig. 6, a diffusion plate 5C is provided on the emission surface side as the emission window 5. Preferably, the diffusion plate 5C be formed by a material having a refractive index greater than or equal to that of the light-guiding substrate 3, and for example, may have a configuration on which a micro lens array is disposed. The diffusion plate 5C can diffuse the light 23 incident at the second incident angle α2 not less than the critical angle θc of the light-guiding substrate 3 and emit the diffused light on the external side. Alternately, instead of the diffusion plate 5C, only a high refraction material layer formed of a material having a refractive index lager than that of the light-guiding substrate 3 may be provided as the emission window 5. The high refraction material layer is configured such that, upon receiving the light 23 incident at the second incident angle α2 not less than the critical angle θc of the light-guiding substrate 3, refracts the light 23 incident at the boundary between the high refraction material layer and the rear surface 32 of the light-guiding substrate 3 and emits the refracted light from the light-guiding substrate 3 as the light 24.

In Fig. 6A, the diffusion plate 5C is provided on a part of the rear surface 32 of the light-guiding substrate 3 and emits the light 24 toward the photocell 10 disposed on the rear side of the light-guiding substrate 3. In Fig. 6B, the diffusion plate 5C is provided on a part of the front surface 31 of the light-guiding substrate 3 and emits the light 24 toward the photocell 10 disposed on the front side of the light-guiding substrate 3.

In the fourth configuration example illustrated in Fig. 7, the emission window 5 is composed as an emission optical system 5D. The emission optical system 5D is an inclined portion inclined with respect to the surfaces of the light-guiding substrate 3, and formed at an end of the light-guiding substrate 3. The inclined portion may be flat or may have a curved surface. The emission optical system 5D refracts, upon receiving the light 23 incident at the second incident angle α2 not less than the critical angle θc, the received light 23 and emits it from the light-guiding substrate 3 as the light 24. Furthermore, it is also possible to form a reflection-type emission window by providing a reflection layer on a surface of the emission optical system 5D.

In Fig. 7A, the emission optical system 5D is provided on a part of the rear surface at an end of the light-guiding substrate 3, and emits the light 24 toward the photocell 10 disposed on the lower side of the light-guiding substrate 3. In Fig. 7B, the emission optical system 5D is provided on a part of the front surface 31 and the rear surface at an end of the light-guiding substrate 3 and emits the light 24 toward the photocell 10 disposed on the lower side of the light-guiding substrate 3. Note that in Fig. 7, the inclined portion is provided at an end surface of the light-guiding substrate 3, the inclined portion may be provided at the front surface or the rear surface. For example, an inclined sheet having an inclined surface may be stuck to emit light via the inclined surface of the inclined sheet.

As described above, according to the light condensing device of the invention, the light 22 reflected at an angle not less than the critical angle θc at the reflection layer 4 for guiding light by the function of the reflection layer 4 for guiding light including the plurality of reflection-type holograms 40 propagates inside the light-guiding substrate 3 while repeating reflection at the front surface 31 and the rear surface 32 of the light-guiding substrate 3, so as to efficiently collect light in a certain direction. Furthermore, designing angle selectivity of the reflection-type hologram 40 with the reflection layer 4 for guiding light makes it possible to control the rate of the light reflected on the reflection layer 4 for guiding light at the reflection angle β so as to adjust lighting properties and visibility.

Furthermore, conventionally, the condensed light has no choice but to be taken out from an end of the light-guiding substrate 3, but the light condensing device 1 of the invention is provided with the emission window 5 at an appropriate position of a surface of the light-guiding substrate 3 so as to emit light from a desired area of the light-guiding substrate without reflecting the light 23 incident at the second incident angle α2 not less than the critical angle θc of the light-guiding substrate 3 on a surface of the light-guiding substrate 3. Employing a transmission layer for emission on which transmission-type holograms are formed or a reflection layer for emission in which reflection-type holograms are formed as the emission window 5 allows the condensed light to reach desired one direction by diffraction by the holograms.

Furthermore, although there has been a restriction in arrangement of a photocell that receives the condensed light and generates electric power, diffraction by the holograms allows the condensed light to reach desired one direction, so as to to dispose a photocell at any place without restriction by surrounding environment. Furthermore, the angle between the light emitted from the emission window and the light receiving surface of the photocell can be appropriately set so as to improve power generation efficiency. Furthermore, since the reflection layer for guiding light can be provided on the interior side of the light-guiding substrate, a light incident surface of the reflection layer for guiding light is in contact with a surface of the light-guiding substrate, preventing the light incident surface from being tainted and reducing risks of deterioration or physical damages. In addition, the light condensing device 1 is applicable to an existing window glass of a house, a building, and the like, and the window glass itself can be used as the light-guiding substrate 3 (hereinafter, also referred to as window glass 3). In this case, the reflection layer 4 for guiding light and the emission window 5 (transmission layer 5A for emission, reflection layer 5B for emission) are preferably configured as a light condensing sheet capable of being easily stuck to the window glass 3.

### [Configuration Example of Light Condensing Sheet]

The light condensing sheet includes a sheet-like hologram photosensitive material. The hologram photosensitive material typically includes at least a hologram recording layer including a photosensitive material, and a base material supporting the hologram recording layer. Silver salt, dichromated gelatin, photopolymer, photoresistor, or the like is used in the hologram recording layer, and a resin such as polyethylene film, polypropylene film, and polyfluoroethylene based film is used in the base material. In the hologram photosensitive material, the hologram recording layer in which a predetermined hologram is recorded becomes the layer that corresponds to the reflection layer 4 for guiding light, the transmission layer 5A for emission, the reflection layer 5B for emission, or the like of the invention.

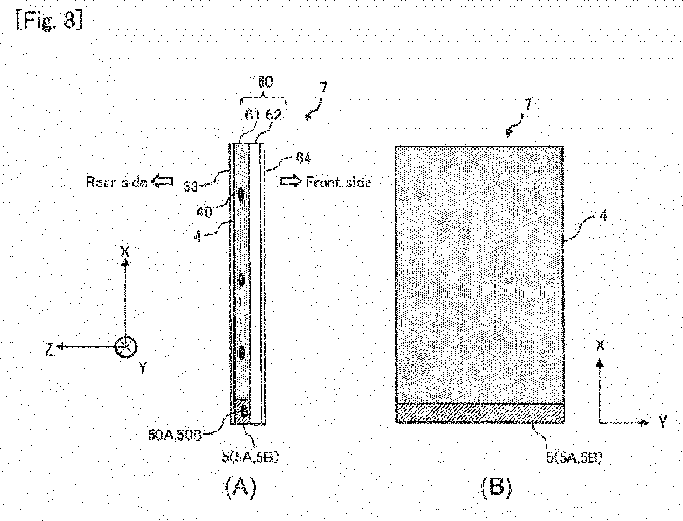

Fig. 8 to Fig. 10 respectively illustrate first to third configuration examples of a light condensing sheet 7 according to the invention. (A) of each of the drawings is a cross-sectional view viewing the light condensing sheet 7 from Y axis direction, and (B) of each of the drawings is a cross-sectional view viewing the light condensing sheet 7 from Z axis direction.

In the first configuration example illustrated in Fig. 8, the light condensing sheet 7 comprises: a hologram photosensitive material 60 including a hologram recording layer 61 and a base material 62; a protective layer 63 provided on a rear side (interior side) of the hologram photosensitive material 60; and an adhesive layer 64 provided on a front side (adhesive side to the light-guiding substrate) of the hologram photosensitive material 60. The reflection-type hologram 40 is formed on a part of the hologram recording layer 61 to compose the reflection layer 4 for guiding light. The transmission-type hologram 50A or the reflection-type hologram 50B is formed on another part of the hologram recording layer 61 to compose the transmission layer 5A for emission or the reflection layer 5B for emission as the emission window 5. The protective layer 63 is composed of a resin or the like and prevents the hologram photosensitive material 60 from being damaged. The adhesive layer 64 is configured to be able to adhere to a surface of the light-guiding substrate 3. The size or the shape of the light condensing sheet 7 can be appropriately set depending on the conditions (size, shape, installation place, sunshine conditions, necessity of daylighting, etc.) of the light-guiding substrate. Furthermore, the light condensing sheet 7 may be manufactured as a sheet having a general-purpose size that matches the size and the shape of the light-guiding substrate, or may be manufactured as a sheet having an excessive size (e.g., a roll long band shape) and configured to be able to be shaped and processed to match the size or the shape of the light-guiding substrate that is a sticking target.

The light condensing sheet 7 of the example can be stuck to, for example, the rear surface of the existing window glass 3 and needs not to largely repair an existing window glass so that the light condensing device can be easily composed with a low cost using the existing window glass 3. Furthermore, since the light condensing sheet 7 is provided on the interior side of the window glass 3, resulting in lessening danger of work. Furthermore, the light condensing sheet 7 is preferably configured to be easily peeled off as needed after being stuck to the existing window glass 3 (light-guiding substrate). This makes it possible to replace the sheet easily even when the light condensing sheet 7 is deteriorated due to irradiation of ultraviolet ray for a long period or the like or even when the light condensing sheet 7 is damaged by a physical impact.

Sticking such a light condensing sheet to a surface of the light-guiding substrate makes it possible to manufacture a light condensing device. Furthermore, a process of washing a surface of the light-guiding substrate may be included before the process of sticking the light condensing sheet to a surface of the light-guiding substrate. Furthermore, a process of shaping the light condensing sheet to match the size or the shape of the light-guiding substrate may be included before the process of sticking the light condensing sheet to a surface of the light-guiding substrate. When the light condensing sheet of the light condensing device is changed, a process of peeling off the light condensing sheet being stuck to the light condensing substrate, and as needed, a process of washing the surface of light-guiding substrate and a process of shaping the light condensing sheet to match the size or the shape of the light-guiding substrate may be included before the process of attaching the light condensing sheet to a surface of the light-guiding substrate,.

Furthermore, in the first configuration example illustrated in Fig. 8, the reflection layer 4 for guiding light and the emission window 5 (transmission layer 5A for emission or reflection layer 5B for emission) are formed as one sheet, but the invention is not limited thereto.

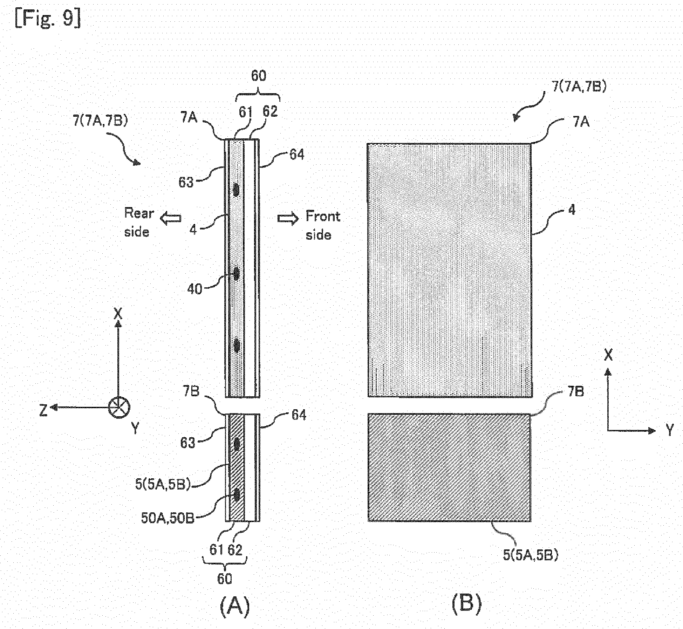

As illustrated in the second configuration example illustrated in Fig. 9, the light condensing sheet 7 may be composed by two separate sheets that are a reflection sheet 7A for guiding light including the reflection layer 4 for guiding light, and a sheet 7B for emission window including emission window 5 (transmission layer 5A for emission or reflection layer 5B for emission).

When the light condensing device is composed by the light condensing sheet 7 of the example, the reflection sheet 7A for guiding light and the sheet B for emission window may be stuck to the rear surface 32 of the existing window glass 3, or the reflection sheet 7A for guiding light may be stuck to the rear surface 32 of the window glass 3 and the sheet 7B for emission window may be stuck to the front surface 31 of the window glass 3.

Furthermore, in the first and second configuration examples, although the light condensing sheet 7 includes one reflection layer 4 for guiding light and one emission window 5, in the light condensing sheet 7, the quantity, the size or the arrangement of the reflection layer 4 for guiding light and the emission window 5 are capable of being appropriately changed depending on an aspect of the window glass.

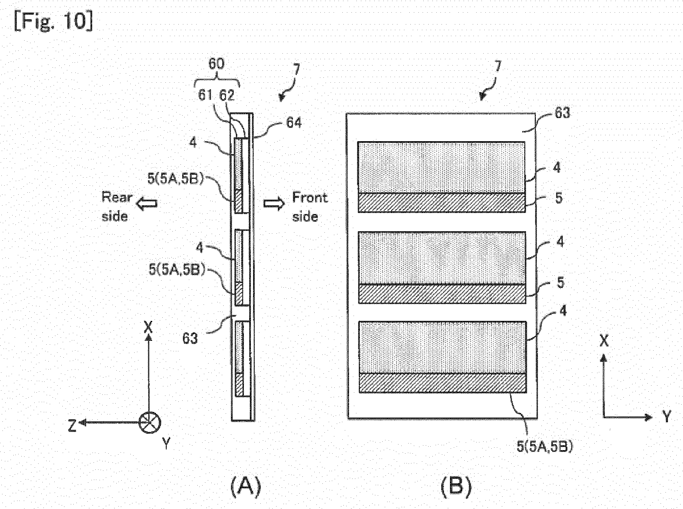

In the third configuration example illustrated in Fig. 10, in the light condensing sheet 7, three hologram photosensitive materials 60 are arranged at intervals, and in each hologram photosensitive material 60, a pair of the reflection layer 4 for guiding light and the emission window 5 is formed, and the hologram photosensitive materials 60 are integrated by the protective layer 63 made of a resin.

The light condensing sheet of the invention is described above, but the above description is only examples, and various modification are possible to match the intended use. Furthermore, a photovoltaic device can be composed by providing the light condensing sheet on the light-guiding substrate and then appropriately providing a photocell at a position at which light emitted from the emission window of the light condensing sheet is received . Furthermore, a photovoltaic device can also be easily composed by configuring a photovoltaic sheet preliminarily embedded in the light condensing sheet and providing the photovoltaic sheet on the light-guiding substrate.

### [Configuration Example of Photovoltaic Sheet]

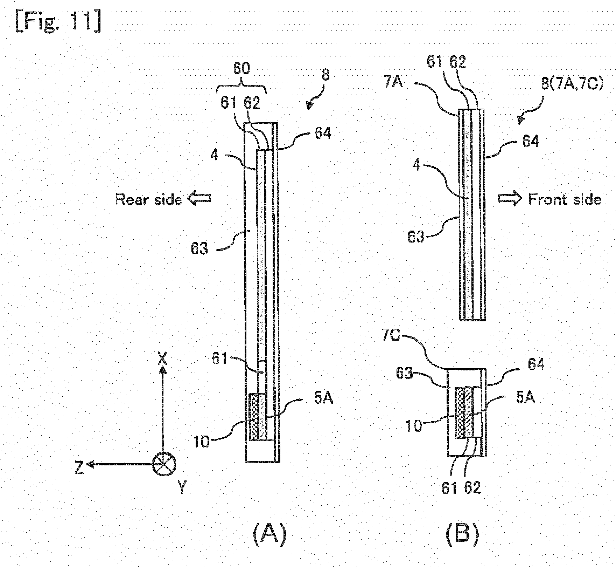

Fig. 11 illustrates a configuration example of a photovoltaic sheet 8 of the invention. In the configuration example illustrated in Fig. 11A, the photovoltaic sheet 8 includes the hologram photosensitive material 60 including the hologram recording layer 61 and the base material 62, the photocell 10, the protective layer 63 provided on the rear side of the hologram photosensitive material 60 (interior side), and the adhesive layer 64 provided on the front side (adhesive side to the light-guiding substrate) of the hologram photosensitive material 60.

The reflection-type holograms 40 are formed in portions of the hologram recording layer 61 to constitute the reflection layer 4 for guiding light. The transmission-type hologram 50A is formed in another portion of the hologram recording layer 61 to compose the transmission layer 5A for emission. The hologram recording layer 61 may include a portion in which no hologram is formed. The photocell 10 is disposed to be adjacent to the transmission layer 5A for emission. The protective layer 63 convers the hologram photosensitive material 60 and the photocell 10 to integrate them to prevent them from being damaged. The adhesive layer 64 is configured to be able to be adhered to a surface of the light-guiding substrate 3.

Furthermore, in the configuration example illustrated in Fig. 11A, although the portion of the reflection layer 4 for guiding light that provides light condensing function, the portion of the transmission layer 5A for emission, and the photocell 10 that provide photovoltaic function are formed as one sheet, but the invention is not limited thereto. As illustrated in the configuration example illustrated in Fig. 11B, the photovoltaic sheet 8 may also be composed of two separate sheets that are the reflection sheet 7A for guiding light and a sheet 7C for emission window with the photocell including the transmission layer 5A for emission and the photocell 10.

In the case where the photovoltaic device is composed by using the existing window glass 3, one photovoltaic sheet 8 may be stuck to the rear surface 32 of the window glass 3, or the reflection sheet 7A for guiding light may be stuck to the rear surface 32 of the window glass 3 and the sheet 7C for emission window with the photocell may be stuck to the front surface 31 or the rear surface 32 of the window glass 3. By means of the photovoltaic sheet according to the invention, the photovoltaic device can be configured with a low cost without largely repairing an existing window glass.

The size or the shape of the photovoltaic sheet 8 can be appropriately set depending on the conditions (size, shape, installation place, sunshine conditions, necessity of daylighting, etc.) of the light-guiding substrate. Furthermore, the photovoltaic sheet 8 may be manufactured as a sheet having a general-purpose size that matches the size and the shape of the light-guiding substrate, or may be manufactured as a sheet having an excessive size (e.g., a roll long band shape) and configured to be able to be shaped and processed to match the size or the shape of the light-guiding substrate that is a sticking target. Furthermore, the photovoltaic sheet 8 is preferably configured to be easily peeled off as needed after being stuck to the existing window glass 3 (light-guiding substrate). This makes it possible to replace the sheet easily even when the photovoltaic sheet 8 is deteriorated due to irradiation of ultraviolet ray for a long period or the like or even when the photovoltaic sheet 8 is damaged by a physical impact.

A photovoltaic device can be manufactured by sticking such a photovoltaic sheet to a surface of the light-guiding substrate. Furthermore, a process of washing a surface of the light-guiding substrate may be included before the process of sticking the photovoltaic sheet to a surface of the light-guiding substrate. Furthermore a process of shaping the photovoltaic sheet to match the size or the shape of the light-guiding substrate may be included before the process of sticking the photovoltaic sheet to a surface of the light-guiding substrate. When the photovoltaic sheet of the photovoltaic device is changed, a process of peeling off the photovoltaic sheet being stuck to the light condensing substrate, and as needed, a process of washing the surface of light-guiding substrate and a process of shaping the photovoltaic sheet to match the size or the shape of the light-guiding substrate may be included before the process of attaching the photovoltaic sheet to a surface of the light-guiding substrate.

### [Propagation Path of Light]

Next, in a case where the transmission layer 5A for emission is employed as the emission window 5, an optical propagation path that is a light path of the light 20 from the light source 2 (hereinafter, also referred to as the sun 2) incident on the light-guiding substrate 3 to the photocell 10 at which the light is received will be described using Fig. 1 and Fig. 4A.

The light 20 emitted from the sun 2 is changed in its elevation angle and azimuth angle during a day, but herein, for simplification, the light 20 from the sun 2 shall be irradiated at an elevation angle φ in a plane including normal line N of the light condensing device 1 and perpendicular to the ground surface (hereinafter, referred to as a vertical reference plane). Furthermore, incidence, reflection, refraction with respect to each component of the light condensing device 1 will be described in the vertical reference plane for simplification.

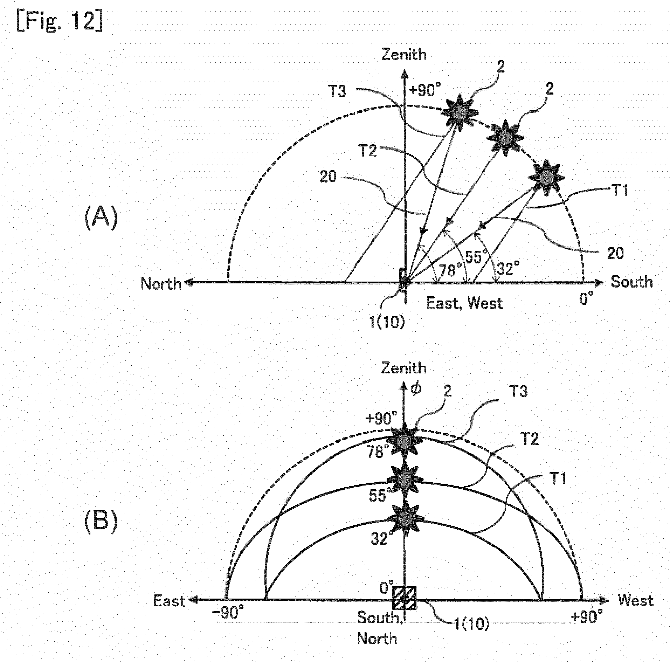

First, the light 20 form the sun 2 is incident on the front surface 31 of the light-guiding substrate 3 at the elevation angle φ. The elevation angle φ during culmination time of the sun differs depending on season and latitude, but for example, at north latitude 35° (Tokyo), as illustrated in Fig. 12 described below, the elevation angle φ is about 32° on the winter solstice, about 55° on the vernal equinox or the autumnal equinox, and about 78° on the summer solstice.

The incident light 20 is refracted at the front surface 31, and the refracted light 21 travels toward the rear surface 32 of the light-guiding substrate 3 at the first incident angle α1 less than the critical angle θc of the light-guiding substrate 3.

Herein, for simplification, supposing that the refractive index of the light-guiding substrate 3 is 1.5 and the refractive index of air is 1.0, the critical angle θc at which total reflection occurs between the front surface 31 and the rear surface 32 of the light-guiding substrate 3 is about 42° from Snell's law.

Then, the light 20 incident at the elevation angle φ of about 32° (winter solstice) is refracted at the front surface 31 of the light-guiding substrate 3 to become the light 21 of about 21° in the first incident angle α1 and travels toward the rear surface 32. Likewise, the light 20 incident at the elevation angle φ of 55° (vernal equinox and autumnal equinox) becomes the light 21 of about 33° in the first incident angle α1 and travels toward the rear surface 32. The light 20 incident at the elevation angle φ of about 78° (summer solstice) becomes the light 21 of about 41° in the first incident angle α1 and travels toward the rear surface 32. In this manner, the light 20 incident at the elevation angle φ within the range of about 32° to 78° is refracted at the front surface 31 of the light-guiding substrate 3 and the refracted light 21 reaches the rear surface 32 of the light-guiding substrate 3 at the first incident angle α1 within the range of 21° to 41°

### (less than the critical angle θc) from Snell's law.

Then, when the light 21 of the first incident angle α1 less than the critical angle θc is incident on the reflection-type hologram 40 formed in the reflection layer 4 for guiding light on the rear surface 32, the incident light 21 is reflected by diffraction effect by the reflection-type hologram 40 to become the light 22 of an angle β not less than the critical angle θc, and the reflected light 22 travels toward the front surface 31.

Note that, when the light 21 is incident at a position where no reflection-type hologram 40 is formed in the reflection layer 4 for guiding light at the first incident angle α1 less than the critical angle θc, the incident light 21 is transmitted through the reflection layer 4 for guiding light, and emitted on the rear side of the light condensing device 1. Furthermore, when the reflection-type hologram 40 is configured to have angle selectivity or wavelength selectivity to interfere with the light within a desired angle range or a wavelength range, the light outside such a desired angle range or a wavelength range is transmitted through the reflection layer 4 for guiding light, and emitted on the rear side of the light condensing device 1. Therefore, the light condensing device 1 also has lighting properties and visibility.

Furthermore, the light 22 reflected toward the front surface 31 is incident on the front surface 31 at the angle β not less than the critical angle θc, so that the light 22 is totally reflected at the front surface 31 at the reflection angle β, and the reflected light 23 is totally reflected also at the rear surface 32 at the reflection angle β in the same manner, and then, propagated in the lower direction inside the light-guiding substrate 3 while repeating total reflection by plural numbers of times.

Note that although the elevation angle φ of the light 20 from the sun 2 may include a range not less than the critical angle θc (e.g., 42°), the light 21 refracted at the front surface 31 reaches the rear surface 32 at the first incident angle α1 less than the critical angle θc in the light-guiding substrate 3 from the relation of the relative refractive index between air and the light-guiding substrate 3. Therefore, it is sufficient that the reflection-type hologram 40 formed on the rear surface 32 is configured to diffract the light incident at less than the critical angle θc. In order words, it is sufficient that the reflection-type hologram 40 of the reflection layer 4 for guiding light uses the light within a range of conical shape whose half angle is the critical angle θc for condensing light to reflect the condensed light to cause total reflection inside the light-guiding substrate 3. In addition, the light that has been reflected by not less than one time inside the light-guiding substrate 3 is incident on the rear surface 32 at an angle not less than the critical angle θc, so that the light that has been reflected by not less than one time needs not to be changed in its reflection angle by the reflection-type hologram 40.

Next, with also reference to Fig. 4A, when the light 23 is incident at the second incident angle α2 not less than the critical angle θc at the position of transmission-type hologram 50A formed in the transmission layer 5A for emission, the incident light 23 reproduces the emission light 24 of a predetermined angle γ by diffraction effect of the transmission-type hologram 50A, and the emission light 24 is emitted in one direction from the rear side of the light-guiding substrate 3. Furthermore, the light that reaches the rear side surface 32 at the first incident angle α1 less than the critical angle θc at the position of the transmission-type hologram 50A formed in the transmission layer 5A for emission is emitted on the rear side without being particularly affected by the transmission-type hologram 50A. However, the transmission-type hologram 50A may be configured to also emit the light incident at the first incident angle α1 from the rear side at the angle γ, and in this case, the light incident at the first incident angle α1 can also be emitted in alignment with the light 22 that have been propagated by total reflection so as to improve light condensing efficiency.

Although the propagation path of light is described above with reference to Fig. 1, the propagation path of light in the light condensing device 1 illustrated in Fig. 2 is also similar to that illustrated in Fig. 1 except that the propagation direction of light is upward direction. Furthermore, in the light condensing device 1 illustrated in Fig. 3, the light 21 incident at the first incident angle α1 on the reflection-type hologram 40 formed at position x2 in the reflection layer 4 for guiding light is propagated in the downward direction similar to the example illustrated in Fig. 1, and the light 23 incident on the emission window 5 is refracted to reach the photocell 10 provided on the rear side of the emission window 5. In contrast, the light 21 incident at the first incident angle α1 on the reflection-type hologram 40 formed at position x3 in the reflection layer 4 for guiding light is propagated in the upward direction similar to the example illustrated in Fig. 2, and the light 23 incident on the emission window 5 is reflected and propagated on the rear side to reach the photocell 10 provided on the rear surface 32 of the light-guiding substrate 3.

Incidentally, in Fig. 1, only propagation in the vertical reference plane is treated as for the light 20 from the sun 2 for illustrative purposes. However, in actual, because of diurnal motion of the sun, the position of the sun viewed from the light condensing device 1 varies depending on time. Furthermore, the orbit of the diurnal motion also differs depending on season.

Fig. 12 is an illustrative diagram illustrating a diurnal motion of the sun 2 for each season. Fig. 12A illustrates an orbit of the sun 2 for each season in a vertical coordinate system of a celestial sphere. Fig. 12B illustrates an orbit of the sun for each season in a horizontal coordinate system of the celestial sphere.

The vertical coordinate system of Fig. 12A is a coordinate viewing a half portion on the zenith side of a large circle having its center at which an observer (the light condensing device 1, the photovoltaic device 100) on a horizontal line is positioned and formed by a south point on the horizontal line, a zenith (point just above observer), a north point on the horizontal line, and a nadir (point just below the observer) from a west point to the direction of an east point on the horizontal line. In Fig. 12A, the angle at which the observer looks up the celestial sphere is the elevation angle, and the horizontal line direction shall be 0° and the zenith shall be 90°.

The horizontal coordinate system of Fig. 12B is a coordinate viewing a half portion on the zenith side of a large circle having its center at which an observer on a horizontal line is positioned formed by an east point on a horizontal line, a zenith, a west point on the horizontal line, and a nadir from a north point to the direction of a south point on the horizon. In Fig. 12B, a direction at which an observer views a point on a horizontal plane is referred to as an azimuth angle, and a direction of a south point on the horizon plane shall be 0°, a direction of an east point on the horizon plane shall be -90°, a direction of a west point on the horizon plane shall be +90°, and a direction of a north point on the horizon plane shall be 180°.

In each coordinate system of Figs. 12A and 12B, orbit T1 of the diurnal motion of the sun on the winter solstice, orbit T2 of diurnal motion of the sun on the vernal equinox and the autumnal equinox, and orbit T3 of diurnal motion of the sun on the summer solstice are illustrated.

Then, as illustrated in the drawings, when an observer is positioned at, for example, north latitude 35° (Tokyo), the culmination altitude of the sun on the winter solstice is lowest among year, and becomes about 32° (90° - latitude at observing point - 23.4°). The culmination altitude on the vernal equinox and the autumnal equinox becomes about 55° ("90° - latitude at observing point"). The culmination altitude of the sun on the summer solstice is highest among year, and becomes about 78° ("90° - latitude at observing point + 23.4°").

Furthermore, as illustrated in the drawings, on the winter solstice (see orbit T1), the sun rises from south side of due east (about - 61° in the case where north latitude is 35°), and sets in south side of due west (about +61° in the case where north latitude is 35°). On the vernal equinox and the autumnal equinox (see orbit T2), the sun rises from due east (about -90°), and sets in due south (+90°). On the summer solstice (see orbit T3), the sun rises from north side of due east (about -119° in the case where north latitude is 35°), and sets in south side of due west (about +119° in the case where north latitude is 35°).

As described above, in the case where the sun is the light source 2, the position of the sun varies depending on time and season. However, since the refractive index of the light-guiding substrate 3 is higher than that that of air, the light 20 from the sun is refracted at the front surface 31 of the light-guiding substrate 3 to be incident on the rear surface 32 of the light-guiding substrate 3 at the first incident angle α1 less than the critical angle θc.

Therefore, in the light condensing device 1 of the invention, the reflection-type hologram preferably has angle selectivity in which the range within the conical shape whose half angle is the critical angle θc is maximum. Furthermore, the reflection-type hologram may be configured to have angle selectivity corresponding to a portion the range of the conical shape whose half angle is the critical angle θc. Hereinafter, a manufacturing device and a manufacturing method of the reflection-type hologram will be described.

### [Manufacturing Device of Reflection-type hologram]

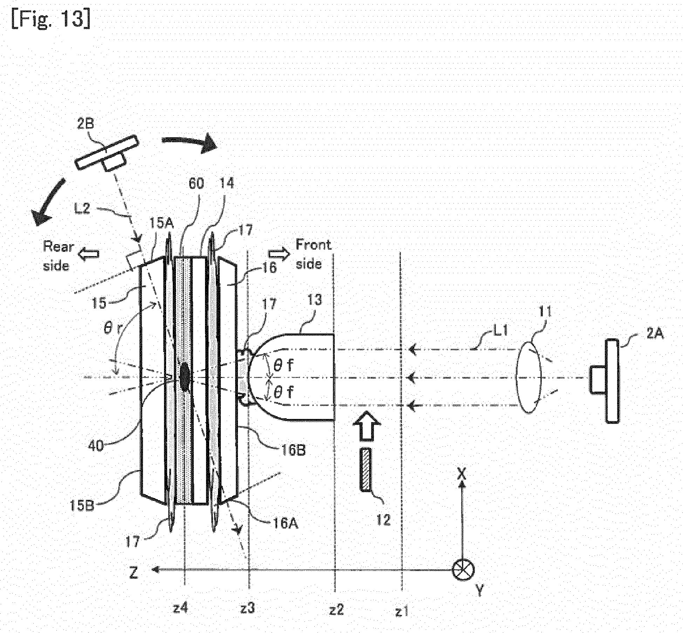

Fig. 13 is an illustrative diagram illustrating an example of a device and a method for manufacturing the reflection-type hologram 40. The manufacturing device includes a laser light source 2A, a laser light source 2B, a collimator lens 11, a light shielding mask 12, an objective lens 13, a mounting table 14, an optical member 15 for introducing reference light, an optical member 16 for emitting reference light, a hologram photosensitive material 60, scanning means (omitted in the drawing), control means (not shown in the drawings), and the like. Additionally, a beam splitter, an expander, an aperture, or the like may be appropriately provided.

The leaser light source 2A is, for example, a semiconductor laser, etc., and object light L1 is converged via the objective lens 13 to be irradiated on the hologram photosensitive material 60. The hologram photosensitive material 60 is a material in which the reflection-type hologram 40 is recorded, and preferably has the refractive index identical to that of the light-guiding substrate 3. The hologram photosensitive material 60 may be one of a protective layer, an adhesive layer, and an adhesive protective layer or may have a structure in which a plurality of them are laminated.

The collimator lens 11 shapes light from the laser light source 2A to be a substantially parallel light. The object light L1 formed to be substantially parallel light is refracted by the objective lens 13 to be irradiated on a recording target portion of the hologram photosensitive material 60 as convergent light. The converged object light L1 to be irradiated on the hologram photosensitive material 60 corresponds to light capable of being interfered with the reflection-type hologram 40, and the reflection-type hologram 40 can interfere with the light incident at the same direction and same angle as the converged object light L1 to regenerate reflection light. Therefore, angle selectivity and direction selectivity of the reflection-type hologram 40 are capable of being adjusted depending on the irradiation angle and irradiation direction of the converged object light L1. For example, the light shielding mask 12 described below can transform the planar shape of object light L1 incident on the objective lens 13, so that angle selectivity and direction selectivity of the reflection-type hologram 40 can be adjusted. In the case of making the light reflection layer 4 for guiding light in Fig. 1, the object light L1 is set to include at least a part of the range less than the critical angle θc (0° to θc) of the light 21 incident on the reflection-type hologram 40 via the light-guiding substrate 3 illustrated in Fig. 1. Furthermore, wavelength selectivity of the reflection-type hologram 40 is also capable of being adjusted depending on the wavelength of the object light L1.

In Fig. 13, the object light L1 having a circular cross section is irradiated so as to be converged to have a conical shape whose half angle is convergent angle θf by the objective lens 13. Convergent angle θf of the object light L1 denotes the maximum incident angle of the converged object light incident on the hologram photosensitive material 60, and when the cross section of the object light L1 is not a circle (in the case where the shape of object light L1 is deformed by the light shielding mask 12, etc.), there is also a case that convergent angle θf differs depending on the orientation in XY plane. Supposing that convergent angle θf is not less than the critical angle θc of the light 21 incident on the reflection-type hologram 40 via the light-guiding substrate 3 illustrated in Fig. 1, the reflection-type hologram 40 becomes capable reflecting incident light less than the critical angle θc (0° to θc), which is preferable.

The light shielding mask 12 is a member disposed between the collimator lens 11 and the objective lens 13, and has an operation of for blocking some of the object light L1, and can be used when an irradiation area having a desired shape is generated with respect to the incident surface of the objective lens 13. This sets a desired angle range to the reflection-type hologram. Preferably, the light shielding mask 12 is configured to be movable by moving means not shown so that the range and the shape of light shielding portion in capable of being changed. As the light shielding mask 12, various shapes and sizes are capable of being employed to provide a desired angle range. Furthermore, a reflection-type hologram having a conical shape may be formed by setting or using no light shielding mask 12.

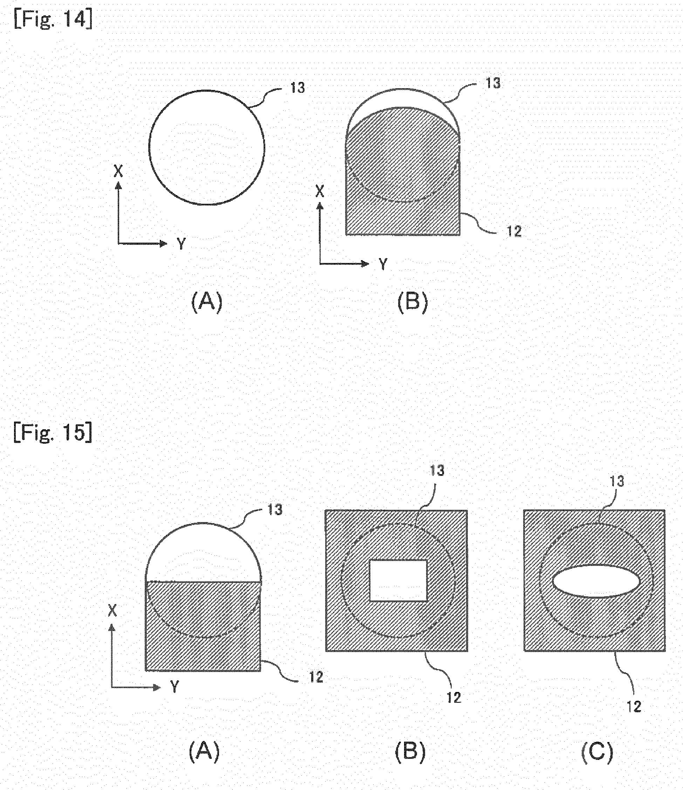

Fig. 14A illustrates an incident surface of the objective lens 13 in a case where no light shielding mask 12 is disposed, and Fig. 14B illustrates an incident surface of the objective lens 13 in a case where the light shielding mask 12 is disposed. The light shielding mask 12 illustrated in Fig. 14B is a member equipped with a curve line greater than the curvature of the incident surface (circular shape) of the objective lens 13, and can form an irradiation area having a crescent shape with respect to the incident surface of the objective lens.

Fig. 15 is an illustrative diagram illustrating another example of the shape of the light shielding mask 12. The light shielding mask 12 illustrated in Fig. 15A is a rectangular member, and can form a semicircular irradiation area with respect to the incident surface of the objective lens. The light shielding mask 12 illustrated in Fig. 15B is a member having a rectangular opening at its center, and capable of forming a rectangular irradiation area with respect to the incident surface of the objective lens. The light shielding mask 12 illustrated in Fig. 15C is a member having an ellipsoidal opening at its center, and capable of forming an ellipsoidal irradiation area with respect to the incident surface of the objective lens.

The mounting table 14 is a transparent member for supporting the hologram photosensitive material 60, and in Fig. 13, is disposed on the front side of the hologram photosensitive material 60. The mounting table 14 is appropriately set depending on the configuration of the device, and for example, may be disposed on the rear side of the hologram photosensitive material 60, or may be arranged on each of both sides thereof. The mounting table 14 makes it possible to reproduce the same optical system as the light incident on the hologram photosensitive material 60 via the light-guiding substrate in use by being disposed similar to the arrangement of the light-guiding substrate in use by using a material having the same refractive index as the structure corresponding the light-guiding substrate, making designing easy. Alternatively, the optical member 15 for introducing reference light and/or the optical member 16 for emitting reference light may be used as the mounting table to support the hologram photosensitive material 60.

The laser light source 2B is, for example, a semiconductor laser or the like and irradiates reference light L2 to a recording target portion of the hologram photosensitive material 60 at an incident angle θr. The reference light L2 is made to be parallel light by an optical system not shown. The incident angle θr of the reference light L2 becomes the emission angle of the reproduction light (reflection light) emitted from the reflection-type hologram 40 after being recorded. When the reflection layer 4 for guiding light in Fig. 1 is manufactured, the incident angle θr corresponds to the reflection angle β of the light 22 to be reflected, and shall be not less than the critical angle θc of the light 21 incident on the reflection-type hologram 40 via the light-guiding substrate 3 illustrated in Fig. 1.

Furthermore, the laser light source 2B is preferably configured such that the incident angle θr with respective to the hologram photosensitive material 60 is appropriately changeable by moving means, a mirror, a prism, or the like not shown. In this case, changing the incident angle θ makes it possible to configure the reflection-type hologram 40 having the reflection angle β different depending on the recording target portions (reference numerals x2 to x4 in Fig. 1) in the same hologram photosensitive material 60. The incident angle θr can be changed in not only the elevation angle direction but also in the azimuth angle direction, and the reflection-type hologram can be configured to emit reproduction light (light 22 in Fig. 1) also in a direction other than the vertical reference plane).

Note that, although in the example illustrated in Fig. 13, although the two laser light sources 2A, 2B are used, the light from one laser light source may be separated into two light fluxes via a beam splitter or the like to use one thereof as the object light L1 and use the other one as reference light L2.

The optical member 15 for introducing reference light is disposed on the rear side of the hologram photosensitive material 60, and is a transparent member having an incident end surface 15A with respect to reference light L2 from the laser light source 2B. Furthermore, the optical member 15 for introducing reference light includes a rear surface 15B for emitting object light L1 passed through the hologram photosensitive material 60 without reflection.

The incident end surface 15A of the optical member 15 for introducing reference light is inclined such that reference light L2 is incident at an angle to be close to be verticality more than the incident angle θr of the reference light L2 with respect to the hologram photosensitive material 60, and preferably, is configured so as to be substantially vertical to the incident angle θr of the reference light L2. Such a configuration is necessary to emit the reference light L2 to the hologram photosensitive material 60 via the optical member 15 for introducing reference light at the incident angle θr not less than the critical angle. Although the critical angle θc is defined by a ratio between the refractive index of air (about 1.0) and the refractive index of the member structuring the light-guiding substrate 3 (e.g., 1.51 in the case of a float glass), the refractive index of the optical member 15 for introducing reference light needs to be greater than at least that of air, and is preferable to be close to the refractive index of the light-guiding substrate 3 as far as possible, and is most preferable to be equal to the refractive index of the light-guiding substrate 3. Supposing that the refractive index of the optical member 15 for introducing reference light is equal to the refractive index of the light-guiding substrate 3, the reference light L2 emitted from the laser light source 2B is refracted due to difference of the refractive indexes when being incident on the optical member 15 for introducing reference light, so that even when the reference light L2 is obliquely irradiated on the rear surface 15B parallel to the hologram photosensitive material 60, the reference light L2 passed through the optical member 15 for introducing reference light fails to be irradiated on the hologram photosensitive material 60 at the desired incident angle θr not less than the critical angle θc due to the refraction. Reducing refraction or eliminating the refraction by inclining the incident end surface 15A on which reference light L2 is incident of the optical member 15 for introducing reference light to make the incident end surface 15A come close to be verticality with respect to the inclined reference light L2 makes it possible to irradiate reference light L2 on the hologram photosensitive material 60 via the optical member 15 for introducing reference light at the incident angle θr not less than the critical angle. Furthermore, the rear surface 15B of the optical member 15 for introducing reference light is preferably a plane parallel with the hologram photosensitive material 60 to make object light L1 be transmitted without being reflected as far as possible.

The optical member 16 for emitting reference light is disposed on the front side of the hologram photosensitive material 60, and is a transparent member having an emission end surface 16A for the reference light L2 transmitted through the hologram photosensitive material 60. Furthermore, the optical member 16 for emitting reference light includes a front surface 16B on which object light L1 passed through the objective lens 13 to be converged is incident. Preferably, the emission end surface 16A is inclined at an angle substantially perpendicular to reference light L2 such that reference light L2 passed through the hologram photosensitive material 60 is transmitted without being reflected as far as possible. Furthermore, the front surface 16B of the optical member 16 for emitting reference light be formed to is preferably a plane in parallel with the hologram photosensitive material 60 such that object light L1 is transmitted without being reflected as far as possible.

Preferably, the objective lens 13, the optical member 16 for emitting reference light, the mounting plate 14, and the optical member 15 for introducing reference light be composed of materials having close refractive indexes, and it is most preferable to be composed of materials having the same refractive indexes. Furthermore, gaps between the objective lens 13, the optical member 16 for emitting reference light, the mounting plate 14, and the optical member 15 for introducing reference light are preferably filled with an immersion liquid 17 having a close refractive index, and it is most preferable to be filled with an immersion liquid 17 having the same refractive index. Employing the same refractive indexes to the members makes object light L1 from the laser light source 2A and reference light L2 from the laser light source 2B travel in a straight line without being refracted at each of the boundary surface between optical members. However, even when the refractive indexes of the members are not equal, the reflection-type hologram 40 can be manufactured by designing an optical system in consideration of refraction as long as refraction caused by a difference between refraction indexes is within an acceptable range.

Furthermore, in the manufacturing device, making the incident end surface 15A of the optical member 15 for introducing reference light be made perpendicular to the reference light L2 and filling the immersion liquid 17 between the optical member 15 for introducing reference light and the hologram photosensitive material 60 makes it possible to make reference light L2 reach a recording target portion of the hologram photosensitive material 60 while keeping an angle not less than the critical angle θc without being refracted at the boundary surfaces (the surface on the front side of the optical member 15 for introducing reference light and the surface on the rear side of the hologram photosensitive material 60). This makes it possible to reproduce the light 22 to be propagated by total reflection at the reflection angle β not less than the critical angle θc inside the light-guiding substrate 3 illustrated in Fig. 1. Furthermore, in the manufacturing device, making the emission end surface 16A of the optical member 16 for emitting reference light be perpendicular to the reference light L2 and filling the immersion liquid 17 between the hologram photosensitive material 60 and the optical member 16 for emitting reference light makes it possible to make reference light L2 transmitted through the recording target portion of the hologram photosensitive material 60 be emitted toward outside without being reflected at the emission end surface 16A. This prevents generation of light retuning to the hologram photosensitive material 60 so as to form a hologram with high accuracy.

Furthermore, the objective lens 13 is preferably configured to make object light L1 incident on the mounting plate 14 (and optical member 16 for emitting reference light) in contact with the hologram photosensitive material 60 via the immersion liquid 17. That is the objective lens 13 functions as a liquid-immersion objective lens.

Herein, the light from the sun (during culmination time on the summer solstice) is incident at an elevation angle up to close to 80° with respect to the normal line of a window glass. Consequently, in order to produce object light of an angle up to an angle θf close to 80°C, in the case where the incident angle is 80° and the refractive index of air is 1.0, the numerical aperture to be required becomes NA = n × sinθf = 1.0 × sin80° ≅ 0.98, so that it is theoretically necessary to use an objective lens having a high resolution and a large incident angle such as numerical aperture NA ≅ 0.98. However, in the case of an objective lens that does not use an immersion liquid, it is considered that the reasonable maximum numerical aperture is about 0.95.

However, as illustrated in Fig. 13, in a case where the liquid-immersion objective lens 13 is used, since a state can be produced in which there is no difference in refractive indexes among the mediums that are objective lens 13, the mounting plate 14 (including a case where the optical member 16 for emitting reference light intermediates), and the immersion liquid, it is sufficient that the light of an angle in the mounting plate 14 can be produced by the objective lens 13. For example, when the light of 80° is incident on the mounting plate 14 having a refractive index of 1.51 from air, the light is refracted to be about 40.5° from Snell's law (sin⁻¹(0.98/ 1.51) ≅ 40.5°) in the mounting plate 14, so that in the case of liquid-immersion objective lens, supposing that the refractive index of the immersion liquid is n = 1.51, there is no difference between the refractive indexes, it becomes sufficient to produce object light of θf ≈ 40.5 by the objective lens 13 to make the object light incident on the mounting plate 14 via the immersion liquid. That is, it is sufficient that numerical aperture NA of the liquid-immersion objective lens 13 is set so as to be able to provide an incident angle of up to about the critical angle θc of the mounting plate 14 in contact with the hologram photosensitive material 60 (the critical angle θc is about 42° in the mounting plate 14 having a refractive index of 1.51), so that there is an advantage in that designing of the optical system becomes easy as compared with the objective lens of above θf = 80°.

Furthermore, the manufacturing device is provided such that relative irradiation positions of object light L1 and reference light L2 in the hologram photosensitive material 60 are movable by scanning means not shown. The scanning means may move the irradiation positions of object light L1 and reference light L2 by changing at least a part of the optical system or orientation or arrangement of an optical member (mirror or prism) without moving the hologram photosensitive material 60, may move the hologram photosensitive material 60 without moving irradiation positions of the object light L1 and reference light L2, or may move the hologram photosensitive material 60 and irradiation positions of object light L1 and reference light L2. The scanning means may, for example, move the relative irradiation position in Y axis direction in Fig. 13 to record one line for the reflection-type hologram 40 and thereafter move the relative irradiation position in X axis direction to record a next line for the reflection-type hologram 40. Alternatively, a plurality of optical systems may be arranged to align in Y axis direction to record one line for the reflection-type hologram 40 by one-shot irradiation, and thereafter move the hologram photosensitive material 60 in the X axis direction.

Alternatively, focal point adjusting means not shown may be included to make a recording target portion of the hologram photosensitive material 60 match a vicinity of the focal point of the objective lens 13. For example, the focal point adjusting means may have a configuration to move the mounting plate 14 and the hologram photosensitive material 60 in Z axis direction between the optical member 15 for introducing reference light and the optical member 16 for emitting reference light, or may have a configuration to move all the optical member 16 for emitting reference light, the mounting plate 14, the hologram photosensitive material 60, and the optical member 15 for introducing reference light with respect to the objective lens 13.

The control means control laser irradiation by the laser light source 2A and the laser light source 2B, arrangement of the light shielding mask 12, the scanning means, and the like to record the reflection-type hologram 40 in the hologram photosensitive material 60.

### [Method for Manufacturing Reflection-type hologram (in Case of Not Using Light Shielding Mask)]

As illustrated in Fig. 13, when the reflection-type hologram is manufactured, first, object light L1 is irradiated from the laser light source 2A. The irradiated object light L1 is shaped to be substantially parallel light via the collimator lens 11 to be incident on the objective lens 13. When the light shielding mask 12 is not used (see Fig. 14A), the cross section of the light flux of the object light L1 is substantially a circular shape. The object light L1 incident on the objective lens 13 is converged into a conical shape whose half angle is convergent angle θf, and incident on the front surface 16B of the optical member 16 for emitting reference light via the immersion liquid 17, and further passed through the optical member 16 for emitting reference light, and incident on a recording target portion of the hologram photosensitive material 60 arranged to match a vicinity of the focal point of the object light L1 via the immersion liquid 17 and the mounting plate 14. The object light L1 passed through the hologram photosensitive material 60 is further incident on the front surface of the optical member 15 for introducing reference light vial the immersion liquid 17 as diverging light, and passed through the optical member 15 for introducing reference light to be emitted from the rear surface 15B.

In contrast, the reference light L2 from the laser light source 2B is made to be parallel light to be irradiated on the optical member 15 for introducing reference light. The irradiated reference light L2 is incident on the incident end surface 15A of the optical member 15 for introducing reference light, and irradiated at the incident angle θr with respect to a recording target portion of the hologram photosensitive material 60 through the inside of the optical member 15 for introducing reference light and through the immersion liquid 17. Then the reference light L2 passed through the hologram photosensitive material 60 is emitted from the emission end surface 16A of the optical member 16 for emitting reference light. The value of the incident angle θr can be appropriately set by appropriately changing orientation of the laser light source 2B (or optical member such as a mirror not shown).

When the object light L1 and reference light L2 intersect at the recording target portion of the hologram photosensitive material 60, an interference fringe caused by the object light L1 that is a light flux having a conical shape whose half angle is the convergent angle θf and the reference light L2 irradiated from the opposite side as parallel light of an incident angle θr is formed, and the reflection-type hologram 40 is recorded.

By repeating the above process of recording the hologram while sequentially moving the relative irradiation position in the hologram photosensitive material 60 by scanning means not shown, a plurality of reflection-type holograms 40 are recorded on the photogram photosensitive material. Furthermore, adjusting moving amount makes it possible to change a recording interval of the reflection-type holograms 40 and thus to record adjacent reflection-type holograms 40 so as to be partially overlapped with each other.

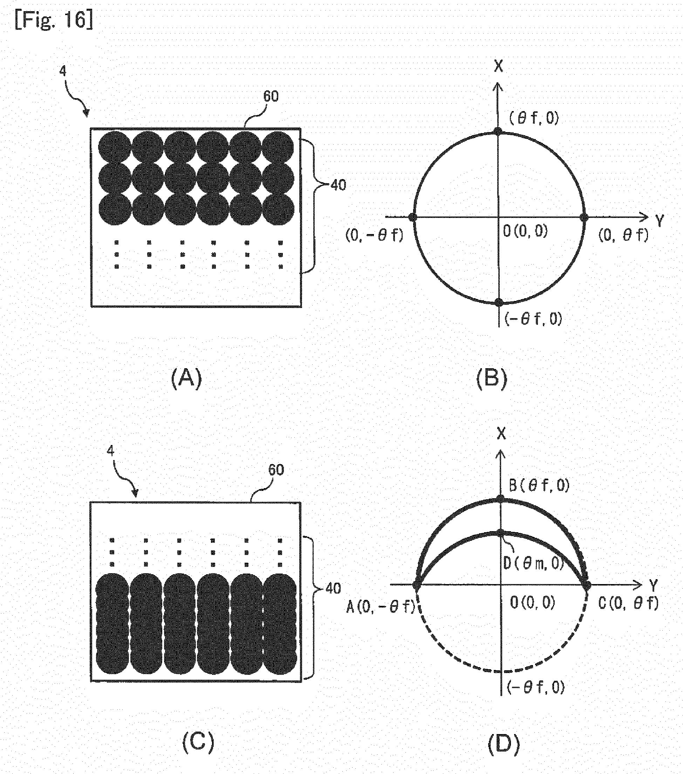

Fig. 16A is an example in which the reflection-type holograms 40 having a circular shape are formed without overlapping with each other in the hologram photosensitive material 60. In the drawing, for the purpose of illustration, the reflection-type hologram 40 is largely displayed, but the reflection-type hologram 40 actually has a fine size of 20 to 1000 µm in its lateral and vertical sizes, and can be confirmed by magnifying the reflection-type hologram 40 by a microscope.

The reflection-type holograms 40 illustrated in Fig. 16A are recorded by the object light L1 that is a light flux having a conical shape whose half angle is the convergent angle θf without using the light shielding mask 12. Consequently, the reflection-type holograms 40 have an angle range corresponding to the conical shape whose half angle is the convergent angle θf, that is, an angle range of -θf to +θf in the X axis direction (azimuth angle direction) and -θf to +θf in the Y axis direction (elevation angle direction) as illustrated by an angle distribution in Fig. 16B. Herewith, such a reflection-type hologram 40 causes diffraction when light less than the convergent angle θf among the angle range corresponding to the light flux having a conical shape narrowed toward its tip is incident, and reproduction light corresponding to the incident angle θr of the reference light L2 is emitted. When the reflection layer 4 for guiding light of Fig. 1 is manufactured, it is preferable to design the reflection layer 4 for guiding light such that the convergent angle θf is set at the critical angle θc of the light-guiding substrate, the incident angle θr of the reference light L2 is set at not less than the critical angle θc of the light-guiding substrate, and when any light (light 21 in Fig. 1) having the first incident angle α less than the critical angle θc is incident, diffraction occurs, and reproduction light (light 22 in Fig. 1) having the angle corresponding to the incident angle θr of reference light L2 (reflection angle β of Fig. 1), which is not less than the critical angle θc, is emitted. Note that, in Fig. 16A, although the reflection-type holograms 40 are aligned in vertical and lateral directions, for example, the reflection-type holograms 40 may be arranged, for example, so as to be staggered between even number rows and add number rows and to arrange reflection-type holograms 40 of each of even number rows at the center position between reflection-type holograms 40 of corresponding adjacent two of the even number rows.

Fig. 16C is an example in which the reflection-type holograms 40 are formed having a circular shape partially overlapping with each other in the hologram photosensitive material 60. In Fig. 16C, when a hologram photosensitive material having small multiplicity is used and when exposure is performed by sequentially shifting an optical spot for exposure in the upper direction of a recording medium, the hologram that is initially exposed becomes a circular shape, but in each of the reflection-type holograms 40 formed thereafter, a portion having a crescent shape that is a light irradiation area to be newly recorded is mainly sequentially formed as a hologram. That is, each of reflection-type holograms 40 to be formed thereafter becomes one that is recorded by a part of the light flux having a conical shape whose half angle is the convergent angle θf.

Such reflection-type holograms 40 have an angle range corresponding to a portion having a crescent shape surrounded by point A (0, -θf), pint B (θf, 0), point C (0, θf), and point D (θm, 0) as illustrated in the angle distribution of Fig. 16D. Angle θm can be set at any angle within a range of 0° < θm < θf depending on the overlapping area of holograms at the time of manufacturing (pitch between holograms), and the angle θm is preferably made to correspond to the lower limit of the elevation angle of the light source. The angle θm may be, for example, culmination altitude of the sun on the winter solstice (about 32° in Tokyo) illustrated in Fig. 12. The reflection-type holograms 40 having a crescent shape causes diffraction when the light having the first incident angle α1 within the angle range is incident, and emits reproduction light having an angle corresponding to the incident angle β of the reference light L2.

In Fig. 16C, although being overlapped only in the vertical direction, the reflection-type holograms 40 may be overlapped also in the lateral direction so as to be able to introduce sun light effectively depending on the latitude and the longitude of an architectural structure, the orientation and inclination of the window to be set, and the like. Furthermore, in Fig. 16C, since the light incident at an incident angle outside the predetermined angle range is transmitted without being totally reflected, there is a characteristic in that lighting properties and visibility are not largely deteriorated.

Note that, when a hologram photosensitive material having a relatively large multiplicity is used, a hologram is recorded also at the portion in which circular holograms are overlapped with each other (portion other than crescent) so that the holograms which enable the light incident within the angle range illustrated in Fig. 16B to be diffracted can be recorded in an overlapped manner.

### [Method for Manufacturing Reflection-type hologram (in Case of Using Light Shielding Mask)]

When a reflection-type hologram is manufactured, object light L1 irradiated from the laser light source 2A is shaped into substantially parallel light via the collimator lens 11, and some of the substantially parallel light is blocked by the light shielding mask 12 disposed between the collimator lens 11 and the objective lens 13, and some other substantially parallel light having a desired shape is incident on the objective lens 13. For example, when the light shielding mask 12 is used having the shape illustrated in Fig. 14B, the cross section of the light flux of object light L1 on the rear side of the light shielding mask 12 becomes a crescent shape.

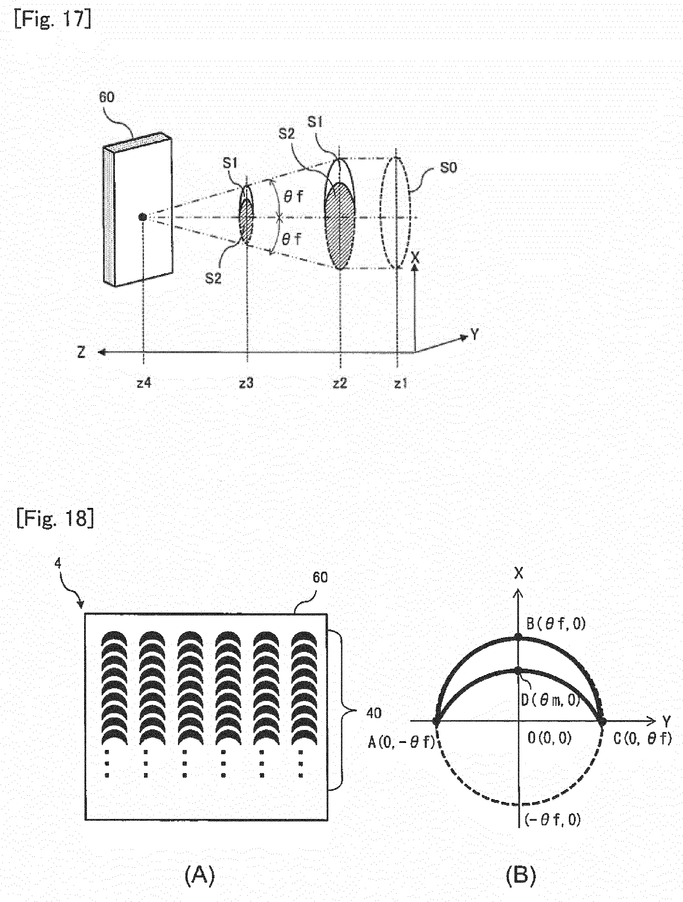

Fig. 17 is an illustrative diagram illustrating an example of object light whose cross section becomes a light flux having a crescent shape. With also reference to Fig. 13, at position z1 on the front side of the light shielding mask 12, the cross-sectional shape of a light flux S0 of object light L1 irradiated from the laser light source 2A becomes a substantially circular shape. At position z2 on the rear side of the light shielding mask 12, the cross-sectional shape of a light flux S1 of the object light L1 becomes a crescent shape, and non-irradiation portion S2 is generated by blocking the light flux by the light shielding mask 12. Furthermore, at position z3 on the rear side of the objective lens 13, by convergence action of the objective lens 13, the cross-sectional shape of the light flux S1 of the object light L1 is narrowed and imaged on a hologram recording target portion of the photogram photosensitive material 60 at position Z4. Then, when the object light L1 and reference light L2 intersect at the recording target portion of the hologram photosensitive material 60, an interference fringe caused by the light flux of the object light L1 having the convergent angle θf and the reference light L2 having the incident angle θr is formed, and the reflection-type hologram 40 having a crescent shape is recorded.

Fig. 18A is an example in which the reflection-type holograms 40 having a crescent shape are formed without being overlapped in the hologram photosensitive material 60. Each of the reflection-type holograms 40 is recorded by a part of a light flux having a conical shape whose half angle is the convergent angle θf. Such reflection-type holograms 40 have an angle range corresponding to a portion having a crescent shape surrounded by point A (0, -θf), pint B (θf, 0), point C (0, θf), and pint D (θm, 0) as illustrated in Fig. 18B. The angle θm can be set at any angle within a range of 0° < θm < θf depending on the shape and the arrangement of the light shielding mask in the manufacturing device, and the angle θm is preferably made to correspond to the lower limit of the elevation angle of the light source. The angle θm may be, for example, culmination altitude of the sun on the winter solstice (about 32° in Tokyo) illustrated in Fig. 12. The reflection-type holograms 40 having a crescent shape causes diffraction when the light having the first incident angle α1 within the angle range is incident, and emits reproduction light having an angle corresponding to the incident angle β of the reference light L2.

The recording mode of the reflection-type holograms illustrated in Fig. 18 can appropriately set the convergent angle θf, the angle θm, the shape the arrangement of the light shielding mask, and the like so as to record holograms having a desired shape and angle range in the elevation angle direction and the azimuth angle direction, and to efficiently condensing light depending on the irradiation direction from the light source. For example, reflection-type holograms having an angle range corresponding to diurnal motion of the sun for each season can be made, and the reflection layer 4 for guiding light capable of efficiently collecting light from the sun can be made.

Furthermore, in Fig. 18, the reflection-type holograms having a crescent shape are capable of being formed as illustrated in Figs. 16C and 16D without overlapping circular holograms with each other. In addition, when a hologram photosensitive material having a relatively large multiplicity is used, the reflection-type holograms having a desired shape and angle range are capable of being recorded with a high density by multiply recording mutual holograms by shifting recording position. In this case, since a plurality of holograms are recorded in an overlapped manner, the light that should be condensed having an incident angle within a predetermined angle range can be totally reflected in substantially the entire area of the hologram photosensitive material so that light condensing properties can be improved. Also in this case, the light incident at an incident angle out of the predetermined angle range is transmitted, preventing visibility from being largely deteriorated.

Although a plurality of embodiments is described above in the present specification, application range of the invention is not limited by each of the embodiments. For example, a plurality of the embodiments can be combined. Reference Numerals

- 1: Light condensing device
- 2: Light source
- 3: Light-guiding substrate
- 4: Reflection layer for guiding light
- 5: Emission window
- 5A: Transmission layer for emission
- 5B: Reflection layer for emission
- 7: Light condensing sheet
- 7A: Reflection sheet for guiding light
- 7B: Sheet for emission window
- 7C: Sheet for emission window with photocell
- 8: Photovoltaic sheet
- 10: Photocell
- 31: Front surface
- 32: Rear surface
- 40: Reflection-type hologram
- 50A: Transmission-type hologram
- 50B: Reflection-type hologram
- 60: Hologram photosensitive material
- 100: Photovoltaic device

## Claims

1. A light condensing device, comprising:
a light-guiding substrate configured to propagate light between a front surface that receives light from a light source and a rear surface;
a reflection layer for guiding light provided on the rear surface, in which a reflection-type hologram is formed, the reflection-type hologram being configured to reflect light, incident at a first incident angle less than a critical angle of the light-guiding substrate, at a reflection angle greater than the critical angle;
and an emission window provided on at least one of the front surface and the rear surface, the emission window being configured to emit light, incident at a second incident angle not less than the critical angle from the light-guiding substrate.

2. The light condensing device according to claim 1, wherein the emission window includes a transmission layer for emission in which a transmission-type hologram is formed, the transmission-type hologram being configured to refract the light, incident at the second incident angle not less than the critical angle, at a refraction angle less than the critical angle.

3. The light condensing device according to claim 1 or 2, wherein the emission window includes a reflection layer for emission in which a reflection-type hologram is formed, the reflection-type hologram being configured to reflect the light, incident at the second incident angle not less than the critical angle, at a reflection angle less than the critical angle.

4. The light condensing device according to any one of claims 1-3, wherein the emission window includes a diffusion plate.

5. The light condensing device according to any one of claims 1-4, wherein the emission window includes an emission optical system having an inclination with respect to the rear surface or the front surface of the light-guiding substrate.

6. The light condensing device according to any one of claims 1-5, wherein the reflection-type hologram in the reflection layer for guiding light is configured to reflect light incident at the first incident angle within a predetermined angle range for an elevation angle direction or an azimuth angle direction.

7. The light condensing device according to any one of claims 1-6, wherein a plurality of types of reflection-type holograms having different reflection angles are formed in the reflection layer for guiding light.

8. The light condensing device according to claim 2, wherein the transmission-type hologram of the transmission layer for emission is configured to emit the light, incident at the second angle and different in an elevation angle direction or an azimuth angle direction, in one direction at a predetermined refraction angle.

9. The light condensing device according to claim 8, wherein the transmission-type hologram of the transmission layer for emission is configured to emit the light incident at the first incident angle in one direction at a predetermined refraction angle.

10. The light condensing device according to any one of claims 1-9, wherein, in the reflection layer for guiding light, a plurality of the reflection-type holograms having a circular shape are formed to partially overlap with each other.

11. The light condensing device according to any one of claims 1-10, wherein, in the reflection layer for guiding light, a plurality of the reflection-type holograms having a crescent shape are formed.

12. A photovoltaic device in which a photocell configured to receive light emitted from an emission window to generate electric power is disposed in the light condensing device according to any one of claims 1-11.

13. The photovoltaic device according to claim 12, wherein the photocell is disposed adjacent to a surface of the light condensing device.

14. A light condensing sheet to be stuck to a light-guiding substrate configured to propagate light between a front surface that receives light from a light source and a rear surface, including:
a reflection layer for guiding light in which a reflection-type hologram configured to reflect light, incident at a first incident angle less than a critical angle of the light-guiding substrate, at a reflection angle greater than the critical angle; and
an emission window formed by a transmission-type hologram, a reflection-type hologram, or a diffusion plate, the emission window being configured to emit light incident at a second incident angle not less than the critical angle.

15. A photovoltaic sheet to be stuck to a light-guiding substrate configured to propagate light between a front surface that receives light from a light source and a rear surface, including:
a reflection layer for guiding light in which a reflection-type hologram configured to reflect light, incident at a first incident angle less than a critical angle of the light-guiding substrate, at a reflection angle greater than the critical angle;
an emission window formed by a transmission-type hologram, a reflection-type hologram, or a diffusion plate, the emission window being configured to emit light incident at a second incident angle not less than the critical angle; and
a photocell configured to receive the light emitted from the emission window to generate electric power.

16. A method for manufacturing a light condensing device configured to condense light from a light source, in which:
a reflection sheet for guiding light in which a reflection-type hologram is formed is stuck to a rear surface of a light-guiding substrate configured to propagate light between a front surface that receives light from a light source and the rear surface, the reflection-type hologram being configured to reflect light, incident at a first incident angle less than a critical angle of the light-guiding substrate, at a reflection angle greater than the critical angle; and
a sheet for an emission window formed by a transmission-type hologram, a reflection-type hologram, or a diffusion plate is stuck to at least one of the front surface and the rear surface of the light-guiding substrate, the sheet for the emission window being configured to emit light incident at a second incident angle not less than the critical angle.

17. A method for manufacturing a photovoltaic device configured to condense light from a light source to generate electric power, in which:
a reflection sheet for guiding light in which a reflection-type hologram is formed is stuck to a rear surface of a light-guiding substrate configured to propagate light between a front surface that receives light from a light source and the rear surface, the reflection-type hologram being configured to reflect light, incident at a first incident angle less than a critical angle of the light-guiding substrate, at a reflection angle greater than the critical angle;
a sheet for an emission window formed by a transmission-type hologram, a reflection-type hologram, or a diffusion plate is stuck to at least one of the front surface and the rear surface of the light-guiding substrate, the sheet for the emission window being configured to emit light incident at a second incident angle not less than the critical angle; and
a photocell is provided at a position to receive the light emitted from the sheet for emission window.

18. A method for manufacturing a light condensing device configured to condense light from a light source, including:
a step of sticking a light condensing sheet to a surface of a light-guiding substrate, the light condensing sheet being configured to include:
a reflection layer for guiding light in which a reflection-type hologram is formed, the reflection-type hologram being configured to reflect light, incident at a first incident angle less than a critical angle of the light-guiding substrate, at a reflection angle greater than the critical angle; and
an emission window configured to emit light incident at a second angle not less than the critical angle.

19. The method for manufacturing the light condensing device according to claim 18, including, before the step of sticking the light condensing sheet to the surface of the light-guiding substrate, one or more steps among:
a step of peeling off a light condensing sheet stuck to the light-guiding substrate;
a step of washing the surface of the light-guiding substrate; and
a step of shaping the light condensing sheet to match a size or a shape of the light-guiding substrate.

20. A method for manufacturing a photovoltaic device configured to condense light from a light source to generate electric power, including:
a step of sticking a photovoltaic sheet to a surface of a light-guiding substrate, the photovoltaic sheet being configured to include:
a reflection layer for guiding light in which a reflection-type hologram is formed, the reflection-type hologram being configured to reflect light, incident at a first incident angle less than a critical angle of the light-guiding substrate, at a reflection angle greater than the critical angle; and
an emission window configured to emit light incident at a second angle not less than the critical angle.

21. The method for manufacturing the photovoltaic device according to claim 20, including, before the step of sticking a photovoltaic sheet to a surface of a light-guiding substrate, one or more steps among:
a step of peeling off a photovoltaic sheet stuck to the light-guiding substrate;
a step of washing the surface of the light-guiding substrate; and
a step of shaping the photovoltaic sheet to match a size or a shape of the light-guiding substrate.
